# EUROPEAN PATENT SPECIFICATION

(11) **EP 4 564 422 B1**
(45) Date of publication and mention of the grant of the patent: **01.07.2026**
(21) Application number: 24214849.2
(22) Date of filing: 22.11.2024
(51) Int. Cl.: H10W 40/25, H10W 70/695, H10W 74/10, H10W 90/00, H02M 3/00, H10W 70/60, H10W 70/685, H10W 70/63, H10W 70/05, H10W 72/30, H10W 76/138, H10W 74/00, H10W 72/00, H10W 70/00, H10W 72/90

(54) **SEMICONDUCTOR DEVICE**
HALBLEITERANORDNUNG
DISPOSITIF SEMI-CONDUCTEUR

(30) Priority: 29.11.2023 JP 2023201704
(43) Date of publication of application: 04.06.2025
(73) Proprietor: Shinko Electric Industries Co., Ltd., Nagano-shi, Nagano 381-2287 (JP)
(72) Inventor: MURAYAMA, Kei, Nagano-shi, 381-2287 (JP); KANEKO, Amane, Nagano-shi, 381-2287 (JP); AIZAWA, Mitsuhiro, Nagano-shi, 381-2287 (JP); NISHIHARA, Yoichi, Nagano-shi, 381-2287 (JP); YUMOTO, Takumi, Nagano-shi, 381-2287 (JP); KOI, Kenichi, Nagano-shi, 381-2287 (JP); KURIHARA, Takashi, Nagano-shi, 381-2287 (JP); BANDO, Koji, Nagano-shi, 381-2287 (JP); TOKUTAKE, Jumpei, Nagano-shi, 381-2287 (JP)
(74) Representative: Groth & Co. KB

(56) References cited:
- US-A1- 2014 264 800
- US-A1- 2020 328 160
- US-A1- 2021 118 859
- US-A1- 2021 134 728
- US-A1- 2022 022 311
- US-A1- 2022 028 774
- DIAHAM S ET AL: "Dielectric breakdown of polyimide films: Area, thickness and temperature dependence", IEEE TRANSACTIONS ON DIELECTRICS AND ELECTRICAL INSULATION, IEEE SERVICE CENTER, PISCATAWAY, NJ, US, vol. 17, no. 1, 1 February 2010 (2010-02-01), pages 18 - 27, XP011302803, ISSN: 1070-9878
- DATABASE MEDLINE [online] US NATIONAL LIBRARY OF MEDICINE (NLM), BETHESDA, MD, US; 8 March 2021 (2021-03-08), ASLAM FAROOQ ET AL: "Improvement of DC Breakdown Strength of the Epoxy/POSS Nanocomposite by Tailoring Interfacial Electron Trap Characteristics.", XP002813019, Database accession no. NLM33800474
- ASLAM FAROOQ ET AL: "Improvement of DC Breakdown Strength of the Epoxy/POSS Nanocomposite by Tailoring Interfacial Electron Trap Characteristics.", MATERIALS (BASEL, SWITZERLAND) 08 MAR 2021, vol. 14, no. 5, 8 March 2021 (2021-03-08), ISSN: 1996-1944

## Description

### BACKGROUND

### 1. Field

This disclosure relates to a semiconductor device.

### 2. Description of Related Art

A power semiconductor device (power module) controls and supplies electric power. Japanese Laid-Open Patent Publication No. 2023-94391 and US 2022/028774 A1 discloses an example of such a semiconductor device. The semiconductor device includes a semiconductor element arranged between a lower substrate and an upper substrate, an encapsulation resin encapsulating the semiconductor element, and a wiring layer formed on the upper surface of the upper substrate. The semiconductor device uses a ceramic substrate as the lower substrate, and an organic substrate as the upper substrate.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a semiconductor device includes at least one semiconductor element having a first electrode pad and a second electrode pad, the first electrode pad formed on a lower surface of the semiconductor element and the second electrode pad formed on an upper surface of the semiconductor element, a first organic substrate arranged on the upper surface of the semiconductor element to cover at least an outer edge of an upper surface of the second electrode pad, a first wiring layer arranged on an upper surface of the first organic substrate and electrically connected to the second electrode pad, a conductive layer formed on the lower surface of the semiconductor element, a second organic substrate arranged on a lower surface of the conductive layer to cover at least an outer edge of the lower surface of the conductive layer, and an encapsulation resin encapsulating the semiconductor element between the first organic substrate and the second organic substrate. The conductive layer includes the first electrode pad. The first organic substrate includes a first substrate body and a first adhesive layer formed on a lower surface of the first substrate body and adhered to the upper surface of the semiconductor element. The second organic substrate includes a second substrate body and a second adhesive layer formed on an upper surface of the second substrate body and adhered to a lower surface of the conductive layer.

Other features and embodiments will be apparent from the following detailed description, the drawings, and the claims.

### BRIEF DESCRIPTION OF THE DRAWINGS

Fig. 1 is a schematic cross-sectional view of a semiconductor device in accordance with a first embodiment taken along line 1-1 in Fig. 2.
Fig. 2 is a schematic plan view of the semiconductor device illustrated in Fig. 1.
Figs. 3, 4, 5, 6, 7, 8, and 9 are schematic cross-sectional views illustrating a method for manufacturing the semiconductor device of Fig. 1.
Fig. 10 is a schematic cross-sectional view of a semiconductor device in accordance with a second embodiment taken along line 10-10 in Fig. 11.
Fig. 11 is a schematic plan view of the semiconductor device illustrated in Fig. 10.
Figs. 12, 13, 14, 15, 16, 17, and 18 are schematic cross-sectional views illustrating a method for manufacturing the semiconductor device of Fig. 10.
Fig. 19 is a schematic cross-sectional view of a semiconductor device in accordance with a third embodiment.
Figs. 20, 21, 22, 23, 24, 25, 26, and 27 are schematic cross-sectional views illustrating a method for manufacturing the semiconductor device of Fig. 19.
Figs. 28, 29, 30, 31, and 32 are schematic cross-sectional views illustrating semiconductor devices of modified examples.

Throughout the drawings and the detailed description, the same reference numerals refer to the same elements. The drawings may not be to scale, and the relative size, proportions, and depiction of elements in the drawings may be exaggerated for clarity, illustration, and convenience.

### DETAILED DESCRIPTION

This description provides a comprehensive understanding of the methods, apparatuses, and/or systems described. Modifications and equivalents of the methods, apparatuses, and/or systems described are apparent to one of ordinary skill in the art. Sequences of operations are exemplary, and may be changed as apparent to one of ordinary skill in the art, with the exception of operations necessarily occurring in a certain order. Descriptions of functions and constructions that are well known to one of ordinary skill in the art may be omitted.

Exemplary embodiments may have different forms, and are not limited to the examples described. However, the examples described are thorough and complete, and convey the full scope of the disclosure to one of ordinary skill in the art.

In this specification, "at least one of A and B" should be understood to mean "only A, only B, or both A and B."

Embodiments will now be described with reference to the drawings.

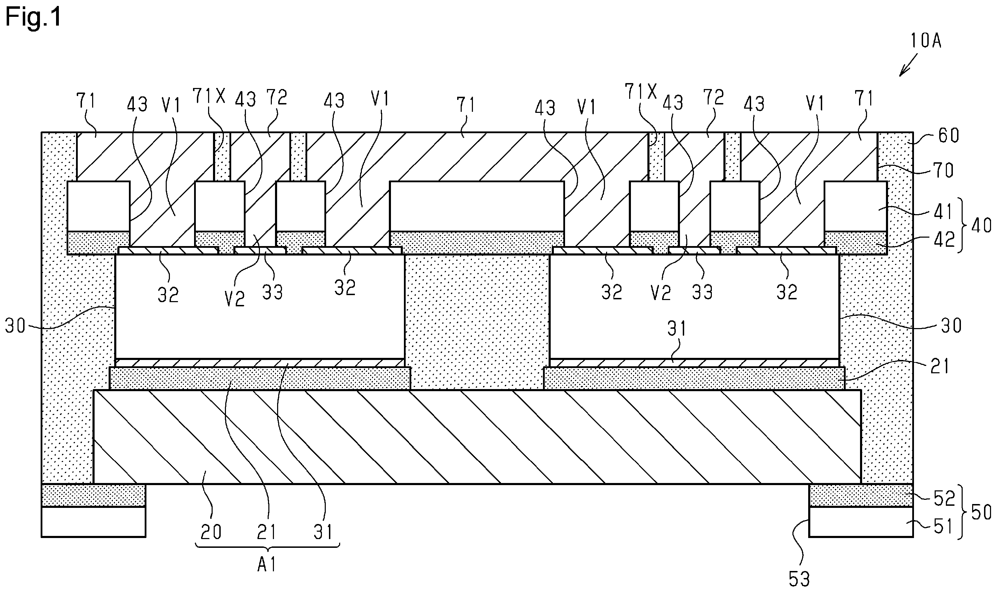

In the accompanying drawings, elements are illustrated for simplicity and clarity and have not necessarily been drawn to scale. In the cross-sectional views, to facilitate understanding of the cross-sectional structure of each member, hatching lines may be replaced by shadings or may not be illustrated. In the plan views, to facilitate understanding of the planar shapes of each member, hatching lines may be added to some of the members. In this specification, a plan view refers to a view taken in a vertical direction (e.g., vertical direction as viewed in Fig. 1), and a planar shape refers to a shape of a subject as viewed in the vertical direction. Further, in this specification, upward, downward, leftward, and rightward directions refer to directions that allow for the reference characters denoting members to be read properly. Further, unless otherwise specified, a numerical range of "X1 to X2," which is specified by upper limit value X1 and lower limit value X2, refers to a range that is greater than or equal to X1 and less than or equal to X2.

### First Embodiment

A first embodiment will now be described with reference to Figs. 1 to 9.

### Overall Structure of Semiconductor Device 10A

The overall structure of a semiconductor device 10A will first be described with reference to Fig. 1.

The semiconductor device 10A is, for example, a power semiconductor device (power module) that controls and supplies electric power. For example, the semiconductor device 10A is a DC-DC converter. The semiconductor device 10A includes a metal plate 20, a bonding portion 21, one or more (four in first embodiment) semiconductor elements 30, and a first organic substrate 40 arranged on upper surfaces of the semiconductor elements 30. Further, the semiconductor device 10A includes a second organic substrate 50 arranged on a lower surface of the metal plate 20, an encapsulation resin 60 encapsulating the semiconductor elements 30, and a wiring layer 70 arranged on an upper surface of the first organic substrate 40. The semiconductor device 10A incorporates the semiconductor elements 30 between the first organic substrate 40 and the second organic substrate 50.

### Structure of Semiconductor Elements 30

Each semiconductor element 30 is joined with the upper surface of the metal plate 20 by the bonding portion 21. The semiconductor element 30 is formed from, for example, silicon (Si) or silicon carbide (SiC). The semiconductor element 30 is, for example, a power semiconductor element. For example, the semiconductor element 30 may be an insulated gate bipolar transistor (IGBT), a metal-oxide-semiconductor field-effect transistor (MOSFET), a diode, or the like. In the first embodiment, the semiconductor element 30 is a MOSFET. The semiconductor element 30 may have a thickness of, for example, about 50 µm to 600 µm. The semiconductor elements 30 have, for example, the same thickness. Each semiconductor element 30 may have a thermal expansion coefficient of, for example, about 3 ppm/°C to 6 ppm/°C.

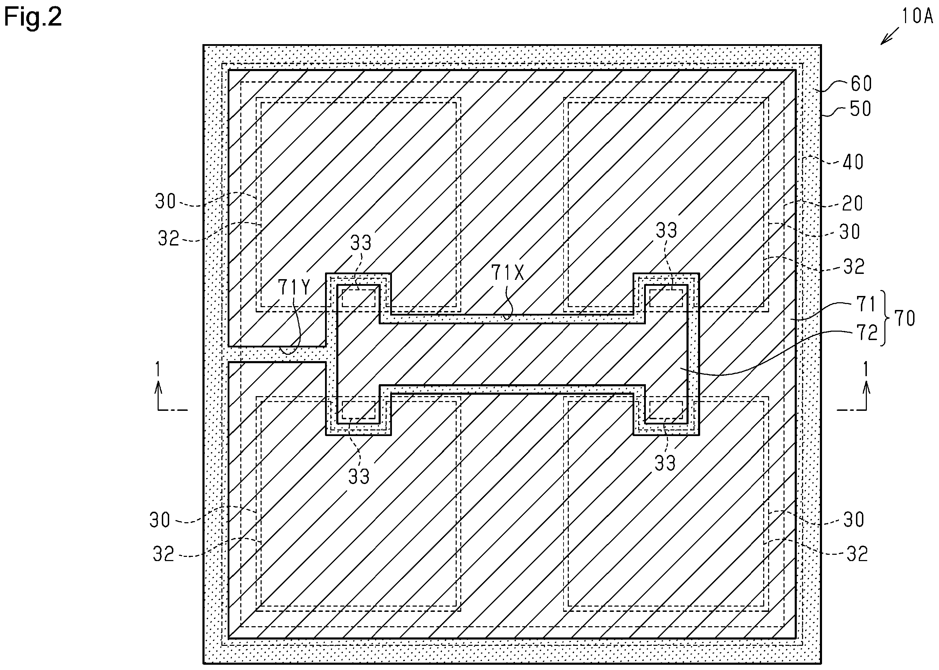

Referring to Fig. 2, each semiconductor element 30 has, for example, a quadrilateral planar shape. The semiconductor element 30 is not limited to a quadrilateral planar shape and may have any planar shape. The four semiconductor elements 30 have, for example, identical planar shapes. The four semiconductor elements 30 are, for example, separated from one another in a planar direction that is orthogonal to a stacking direction of the semiconductor device 10A. For example, the four semiconductor elements 30 are arranged next to one another in the horizontal direction and the vertical direction as viewed in Fig. 2.

Referring to Fig. 1, each semiconductor element 30 includes, for example, an electrode pad 31, an electrode pad 32, and an electrode pad 33. The electrode pad 31 is formed on, for example, the lower surface of the semiconductor element 30. The electrode pad 31 covers, for example, the entire lower surface of the semiconductor element 30. The electrode pads 32 and 33 are formed on, for example, the upper surface of the semiconductor element 30. The electrode pads 32 and 33 are spaced apart from each other on the upper surface of the semiconductor element 30. The electrode pad 31 is, for example, a drain electrode of the MOSFET. The electrode pad 32 is, for example, a source electrode of the MOSFET. The electrode pad 33 is, for example, a gate electrode of the MOSFET.

The electrode pads 31, 32, and 33 may be formed from, for example, a metal, such as aluminum (Al) or copper (Cu), or an alloy including at least one of these metals. When necessary, a surface-processed layer is formed on the surfaces of the electrode pads 31, 32, and 33. Examples of the surface-processed layer include a gold (Au) layer, a nickel (Ni) layer/Au layer (metal layer in which Ni layer serves as bottom layer, and Au layer is formed on Ni layer), Ni layer/palladium (Pd) layer/Au layer (metal layer in which Ni layer serves as bottom layer, with Ni layer, Pd layer, and Au layer are sequentially stacked in this order). The Au layer, the Ni layer, and the Pd layer may each by, for example, a metal layer formed through an electroless plating process, that is, an electroless plating layer. An Au layer is a metal layer formed from Au or an Au alloy, an Ni layer is a metal layer formed from Ni or an Ni alloy, and a Pd layer is a metal layer formed from Pd or a Pd alloy.

### Structure of Metal Plate 20

The metal plate 20 is flat. The metal plate 20 may be formed from, for example, a metal, such as aluminum or copper, or an alloy including at least one of these metals. In the first embodiment, the metal plate 20 is a copper plate.

Referring to Fig. 2, the metal plate 20 has, for example, a quadrilateral planar shape. The metal plate 20 is not limited to a quadrilateral planar shape and may have any planar shape. The metal plate 20 has, for example, a larger planar size than each of the semiconductor elements 30. The metal plate 20 overlaps, for example, all the four semiconductor elements 30 in plan view. The metal plate 20 has a thickness of, for example, about 200 µm to **400** µm. The metal plate 20 may have a thermal expansion coefficient of, for example, about 15 ppm/°C to 18 ppm/°C.

### Structure of Bonding Portion 21

Referring to Fig. 1, the bonding portion 21, which is conductive, joins the semiconductor elements 30 and the upper surface of the metal plate 20. The bonding portion 21 electrically connects the metal plate 20 and the electrode pad 31 of each semiconductor element 30.

The bonding portion 21 is provided, for example, on each of the semiconductor elements 30. In the first embodiment, the bonding portion 21 is joined with the electrode pad 31 of each semiconductor element 30 and with the metal plate 20. Thus, each electrode pad 31 is electrically connected to the metal plate 20 by the bonding portion 21.

The bonding portion 21 may be formed from, for example, a metal sintering material. The sintering material may be, for example, a sintering material of which the main component is silver (Ag) particles (silver sintering material) or a sintering material of which the main component is copper particles (copper sintering material). Further, the material of the bonding portion 21 may be, for example, solder, a conductive paste such as silver paste, or a brazing metal. The bonding portion 21 may have a thickness of, for example, about 10 µm to 60 µm.

In the semiconductor device 10A, the electrode pad 31, the bonding portion 21, and the metal plate 20 form a conductive layer A1.

### Structure of First Organic Substrate 40

The first organic substrate 40 is arranged on the upper surfaces of the semiconductor elements 30. The first organic substrate 40 is flat. The first organic substrate 40 covers at least the edges of the upper surfaces of the electrode pads 32. The first organic substrate 40, for example, entirely covers the upper surfaces of the electrode pads 32. The first organic substrate 40 covers at least the edges of the upper surface of each electrode pad 33. The first organic substrate 40 entirely covers the upper surface of each electrode pad 33.

Referring to Fig. 2, the first organic substrate 40 has, for example, a quadrilateral planar shape. The first organic substrate 40 is not limited to a quadrilateral planar shape and may have any planar shape. The first organic substrate 40 has, for example, a larger planar size than each of the semiconductor elements 30. The first organic substrate 40 overlaps, for example, all the four semiconductor elements 30 in plan view. The first organic substrate 40 has, for example, a larger planar size than the metal plate 20. The first organic substrate 40 has, for example, a slightly larger planar size than the metal plate 20. The first organic substrate 40 entirely overlaps, for example, the metal plate 20 in plan view.

Referring to Fig. 1, the first organic substrate 40 includes, for example, a first substrate body 41 and a first adhesive layer 42 formed on the lower surface of the first substrate body 41. The first substrate body 41 is formed from an organic material. The first substrate body 41 is formed from a resin having a high withstand voltage. An insulative resin having a high withstand voltage (dielectric withstand voltage) may be used as the material of the first substrate body 41. The material of the first substrate body 41 may be, for example, an insulative resin such as polyimide resin or polyester resin. In the first embodiment, the first substrate body 41 is formed from a polyimide resin. The first substrate body 41 has a higher withstand voltage than, for example, the encapsulation resin 60. The withstand voltage of the first substrate body 41 is, for example, 200 kV/mm or greater. The withstand voltage of the first substrate body 41 is, for example, preferably 300 kV/mm or greater, and more preferably, 350 kV/mm or greater. In the first embodiment, the withstand voltage of the first substrate body 41 is 380 kV/mm. The first substrate body 41 has a thickness of, for example, about 30 µm to 150 µm.

The first adhesive layer 42 may be, for example, an epoxy-based, polyimide-based, or silicone-based adhesive. The first adhesive layer 42 has a thickness of, for example, about 15 µm to 45 µm. The first organic substrate 40 may have a thermal expansion coefficient of, for example, about 20 ppm/°C to 27 ppm/°C.

The first substrate body 41 is, for example, adhered by the first adhesive layer 42 to the upper surfaces of the semiconductor elements 30. The first adhesive layer 42 is adhered to the upper surface of each semiconductor element 30 and to the lower surface of the first substrate body 41. The first adhesive layer 42, for example, extends around part of each semiconductor element 30. In other words, the semiconductor elements 30 are partially embedded in the first adhesive layer 42. For example, the electrode pads 32 and 33 of the semiconductor elements 30 are partially embedded in the first adhesive layer 42. The first adhesive layer 42 covers, for example, the side surfaces of the electrode pads 32 and 33.

Through holes 43 extend through the first organic substrate 40 in a thickness direction of the first organic substrate 40. Each through hole 43 extends in the thickness direction through, for example, the first substrate body 41 and the first adhesive layer 42. The through holes 43, for example, partially expose the upper surfaces of the electrode pads 32 and 33.

### Structure of Wiring Layer 70

The wiring layer 70 is formed on the upper surface of the first organic substrate 40. The wiring layer 70 includes at least one (in this case, one) wiring pattern 71 and at least one (in this case, one) wiring pattern 72.

The wiring patterns 71 and 72 may be formed from, for example, copper or copper alloy. When necessary, a surface-processed layer is formed on the surfaces (upper surfaces and side surfaces or only upper surfaces) of the wiring patterns 71 and 72. Examples of the surface-processed layer include a metal layer such as a Au layer, a Ni layer/Au layer, and a Ni layer/ Pd layer/Au layer. The wiring patterns 71 and 72 may have a thickness of, for example, about 50 µm to 200 µm. The wiring layer 70 may have a thermal expansion coefficient of, for example, about 15 ppm/°C to 18 ppm/°C.

As illustrated in Fig. 2, the wiring patterns 71 and 72 are spaced apart from each other on the upper surface of the first organic substrate 40. The wiring patterns 71 and 72 may each have any planar shape.

### Structure of Wiring Pattern 71

Referring to Fig. 1, the wiring pattern 71 is electrically connected to, for example, the electrode pads 32 by via wires V1 formed in the through holes 43, which partially expose the upper surfaces of the electrode pads 32. The wiring pattern 71 is formed integrally with, for example, the via wires V1. In the first embodiment, the wiring pattern 71 is formed integrally with the via wires V1. The via wires V1 are, for example, separated from one another in the planar direction (lateral direction as viewed in Fig. 1). Each via wire V1, for example, fills the corresponding one of the through holes 43. Each via wire V1 extends through the first substrate body 41 and the first adhesive layer 42 in the thickness direction.

Referring to Fig. 2, the overall wiring pattern 71 has, for example, a quadrilateral planar shape. The wiring pattern 71 spreads, for example, on the entire upper surface of the first organic substrate 40. The wiring pattern 71 includes, for example, an open portion 71X, which is located at a central part of the wiring pattern 71 in plan view, and an open portion 71Y, which extends from the open portion 71X in the planar direction (in this case, lateral direction as viewed in Fig. 2). The open portions 71X and 71Y extend through the wiring pattern 71 in the thickness direction.

The open portion 71X is configured to accommodate the wiring pattern 72. The open portion 71X is shaped to extend along the edges of the wiring pattern 72 in plan view. The overall open portion 71X has, for example, an H-shaped planar shape. The open portion 71X allows the wiring pattern 71 to surround the wiring pattern 72. The wiring pattern 71 partially overlaps the semiconductor elements 30 in plan view. The wiring pattern 71 overlaps the electrode pads 32 of the semiconductor elements 30 in plan view. The wiring pattern 71 overlaps, for example, all four of the electrode pads 32 in plan view. The wiring pattern 71 is electrically connected to, for example, all four of the electrode pads 32. Further, the wiring pattern 71 connects the four electrode pads 32 to one another. In other words, the four electrode pads 32 are electrically connected to one another by the wiring pattern 71. The wiring pattern 71 does not overlap the electrode pads 33 of the semiconductor elements 30 in plan view.

The open portion 71Y is in communication with the open portion 71X. The open portion 71Y extends from the open portion 71X in the planar direction (lateral direction as viewed in Fig. 2) to an outer side surface of the wiring pattern 71. The open portion 71Y is, for example, strip-shaped and extends in the lateral direction as viewed in Fig. 2 to have a predetermined width measured in the vertical direction as viewed in Fig. 2.

### Structure of Wiring Pattern 72

Referring to Fig. 1, the wiring pattern 72 is electrically connected to, for example, the electrode pads 33 by via wires V2 formed in the through holes 43, which partially expose the upper surfaces of the electrode pads 33. The wiring pattern 72 is formed integrally with, for example, the via wires V2. In the first embodiment, the wiring pattern 72 is formed integrally with the via wires V2. The via wires V2 are, for example, separated from one another in the planar direction (lateral direction as viewed in Fig. 1). Each via wire V2, for example, fills the corresponding one of the through holes 43. Each via wire V2 extends through the first substrate body 41 and the first adhesive layer 42 in the thickness direction.

As illustrated in Fig. 2, the overall wiring pattern 72 has, for example, an H-shaped planar shape. The wiring pattern 72 overlaps the electrode pads 33 of the semiconductor elements 30 in plan view. The wiring pattern 72 overlaps, for example, all four of the electrode pads 33. The wiring pattern 72 is electrically connected to, for example, all four of the electrode pads 33. Further, the wiring pattern 72 connects the four electrode pads 33 to one another. In other words, the four electrode pads 33 are electrically connected to one another by the wiring pattern 72.

### Structure of Second Organic Substrate 50

Referring to Fig. 1, the second organic substrate 50 is arranged on the lower surface of the metal plate 20. The second organic substrate 50 is flat. The second organic substrate 50 covers at least the edges of the lower surface of the conductive layer A1. In the first embodiment, the second organic substrate 50 covers at least the edges of the lower surface of the metal plate 20, which is located at the lowermost part of the conductive layer A1. The second organic substrate 50 covers, for example, all the edges of the lower surface of the metal plate 20.

The second organic substrate 50 projects outward from, for example, the outer side surfaces of the metal plate 20. The second organic substrate 50 projects outward from, for example, the outer side surfaces of the first organic substrate 40.

The second organic substrate 50 includes, for example, a second substrate body 51 and a second adhesive layer 52 formed on the upper surface of the second substrate body 51. The second substrate body 51 is formed from an organic material. The second substrate body 51 is formed from a resin having a high withstand voltage. An insulative resin having a high withstand voltage may be used as the material of the second substrate body 51. The material of the second substrate body 51 may be, for example, an insulative resin such as polyimide resin or polyester resin. The second substrate body 51 and the first substrate body 41 may be formed from the same material or from different materials. In the first embodiment, the second substrate body 51 is formed from the same type of polyimide resin as the first substrate body 41. The second substrate body 51 has, for example, a higher withstand voltage than the encapsulation resin 60. The withstand voltage of the second substrate body 51 is, for example, 200 kV/mm or greater. The withstand voltage of the second substrate body 51 is, for example, preferably 300 kV/mm or greater, and more preferably, 350 kV/mm or greater. In the first embodiment, the withstand voltage of the second substrate body 51 is 380 kV/mm. The second substrate body 51 has a thickness of, for example, 20 µm to 50 µm.

The second adhesive layer 52 may be, for example, an epoxy-based, polyimide-based, or silicone-based adhesive. The second adhesive layer 52 has a thickness of, for example, about 15 µm to 45 µm.

The second organic substrate 50 and the first organic substrate 40 have, for example, about the same thermal expansion coefficient. In the present specification, the phrase "about the same thermal expansion coefficient" refers to a situation in which the difference in thermal expansion coefficient between the first organic substrate 40 and the second organic substrate 50 is within a range of 10 ppm/°C or less. The thermal expansion coefficient of the second organic substrate 50 may be, for example, about 20 ppm/°C to 27 ppm/°C. The difference between the thermal expansion coefficient of the second organic substrate 50 and the thermal expansion coefficient of the first organic substrate 40 is, for example, less than the difference between the thermal expansion coefficient of the second organic substrate 50 and the thermal expansion coefficient of the semiconductor elements 30. The difference between the thermal expansion coefficient of the second organic substrate 50 and the thermal expansion coefficient of the first organic substrate 40 is, for example, less than the thermal expansion coefficient of the second organic substrate 50 and the thermal expansion coefficient of the encapsulation resin 60.

The second substrate body 51 is, for example, adhered by the second adhesive layer 52 to the lower surface of the metal plate 20. The second adhesive layer 52 is adhered to the lower surface of the metal plate 20 and to the upper surface of the second substrate body 51. The second adhesive layer 52 may, for example, extend around part of the metal plate 20. In other words, the metal plate 20 may be partially embedded in the second adhesive layer 52. In this case, the second adhesive layer 52 may cover, for example, the lower part of each side surface of the metal plate 20.

The second organic substrate 50 includes an open portion 53 extending through the second organic substrate 50 in the thickness direction. The open portion 53 extends in the thickness direction through, for example, the second substrate body 51 and the second adhesive layer 52. The open portion 53 partially exposes the lower surface of the metal plate 20. The open portion 53 exposes, for example, the central part of the lower surface of the metal plate 20. The lower surface of the metal plate 20 exposed from the open portion 53 functions as, for example, an external connection pad. The lower surface of the metal plate 20 exposed from the open portion 53 is connected to, for example, an external connection terminal used to mount the semiconductor device 10A on a mounting substrate such as a motherboard.

### Structure of Encapsulation Resin 60

The encapsulation resin 60 encapsulates the semiconductor elements 30, which are arranged between the first organic substrate 40 and the second organic substrate 50. The encapsulation resin 60 encapsulates, for example, the plurality of (in this case, four) semiconductor elements 30 together. The encapsulation resin 60 entirely covers, for example, the side surfaces of each semiconductor element 30, the upper surface of the bonding portion 21 exposed from each semiconductor element 30, and the side surfaces of the bonding portion 21. The encapsulation resin 60 entirely covers, for example, the upper surface of the metal plate 20 exposed from the bonding portion 21.

The encapsulation resin 60 is arranged on, for example, the upper surface of the second organic substrate 50 that is exposed from the metal plate 20. The encapsulation resin 60 entirely covers the upper surface of the second organic substrate 50 that is exposed from the metal plate 20. The encapsulation resin 60 exposes the outer side surfaces of the second organic substrate 50. The outer side surfaces of the encapsulation resin 60 are, for example, flush with the outer side surfaces of the second organic substrate 50. The encapsulation resin 60 covers, for example, the outer side surfaces of the metal plate 20. The encapsulation resin 60 entirely covers, for example, the outer side surfaces of the metal plate 20. The encapsulation resin 60 covers, for example, all the outer side surfaces of the metal plate 20. The encapsulation resin 60 surrounds, for example, the metal plate 20 from the outer side. The encapsulation resin 60 exposes, for example, the lower surface of the metal plate 20.

The encapsulation resin 60 covers, for example, the outer side surfaces of the first organic substrate 40. The encapsulation resin 60 entirely covers, for example, the outer side surfaces of the first organic substrate 40. The encapsulation resin 60 covers, for example, all the outer side surfaces of the first organic substrate 40. The encapsulation resin 60 surrounds, for example, the first organic substrate 40 from the outer side. The encapsulation resin 60 entirely covers, for example, the lower surface of the first organic substrate 40 exposed from the semiconductor elements 30.

The encapsulation resin 60 covers, for example, the upper surface of the first organic substrate 40. The encapsulation resin 60 entirely covers, for example, the upper surface of the first organic substrate 40 exposed from the wiring layer 70. The encapsulation resin 60 covers, for example, the side surfaces of the wiring layer 70. The encapsulation resin 60 entirely covers, for example, the side surfaces of the wiring layer 70. The encapsulation resin 60 is in contact with, for example, the side surfaces of the wiring layer 70. The encapsulation resin 60 surrounds, for example, the wiring patterns 71 and 72. As illustrated in Fig. 2, the encapsulation resin 60 fills, for example, the open portions 71X and 71Y of the wiring pattern 71. Referring to Fig. 1, the encapsulation resin 60 exposes, for example, the upper surface of the wiring layer 70. The upper surface of the encapsulation resin 60 is flush with, for example, the upper surface of the wiring layer 70.

The material of the encapsulation resin 60 may be, for example, a non-photosensitive insulative resin of which the main component is a thermosetting resin. The material of the encapsulation resin 60 may be, for example, an insulative resin such as epoxy resin or polyimide resin, or a resin material prepared by mixing such resins with a filler such as silica or alumina. The encapsulation resin 60 may be, for example, a molding resin. The encapsulation resin 60 may have a thermal expansion coefficient of, for example, about 5 ppm/°C to 18 ppm/°C.

### Method for Manufacturing Semiconductor Device 10A

A method for manufacturing the semiconductor device 10A will now be described. To simplify illustration, elements that will consequently become the final elements of the semiconductor device 10A are given the same reference characters as the final elements.

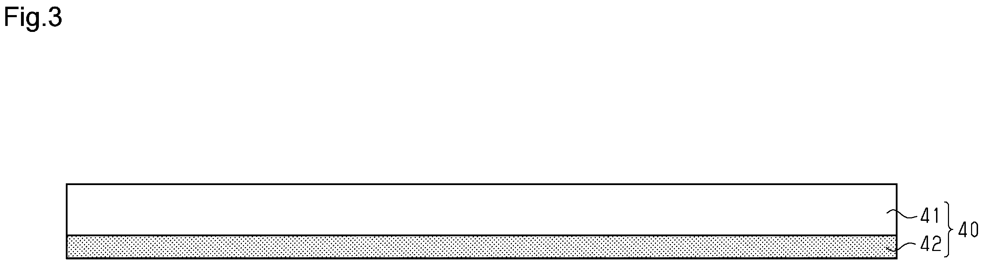

In the step illustrated in Fig. 3, the first organic substrate 40 is prepared. In this case, the first organic substrate 40 is structured by applying the first adhesive layer 42 to the lower surface of the first substrate body 41.

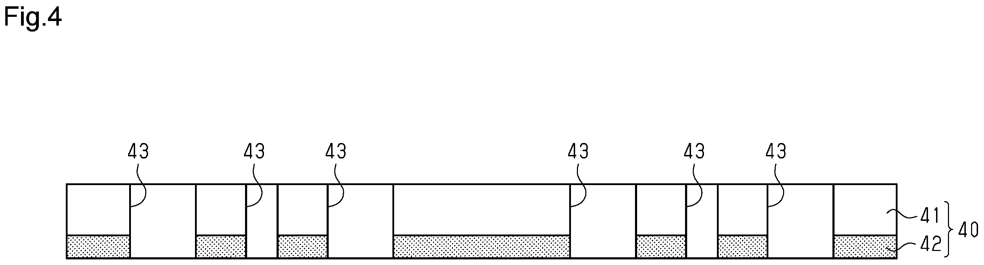

In the step illustrated in Fig. 4, the through holes 43 are formed in the first organic substrate 40 at given locations. The through holes 43 extend through the first substrate body 41 and the first adhesive layer 42 in the thickness direction. The through holes 43 may be formed, for example, through laser processing using a CO₂ laser or a UV-YAG laser or through a punching process.

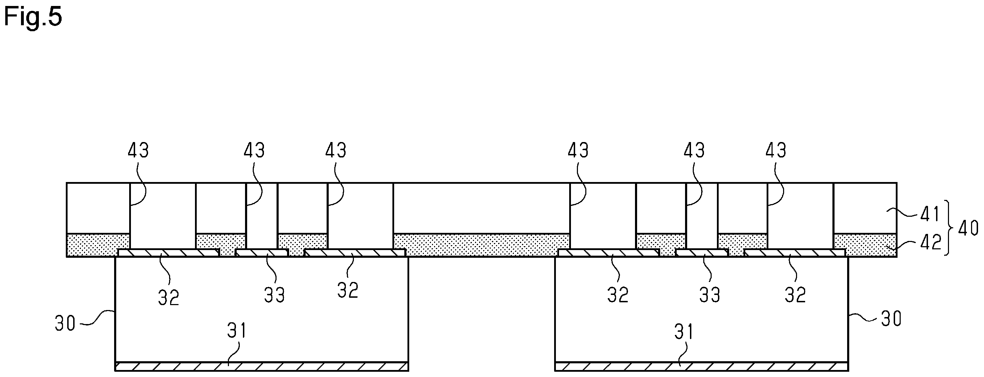

In the step illustrated in Fig. 5, the semiconductor elements 30, which include the electrode pads 31, 32, and 33, are prepared. Then, the first organic substrate 40 is mounted on the upper surfaces of the semiconductor elements 30. For example, the first organic substrate 40 is adhered to the upper surfaces of the semiconductor elements 30 with the first adhesive layer 42. For example, a sheet of the first organic substrate 40 is laminated into the upper surfaces of the semiconductor elements 30 through thermal compression bonding. In this step, the semiconductor elements 30 and the first organic substrate 40 are positioned so that the upper surfaces of the electrode pads 32 and 33 are partially exposed from the through holes 43.

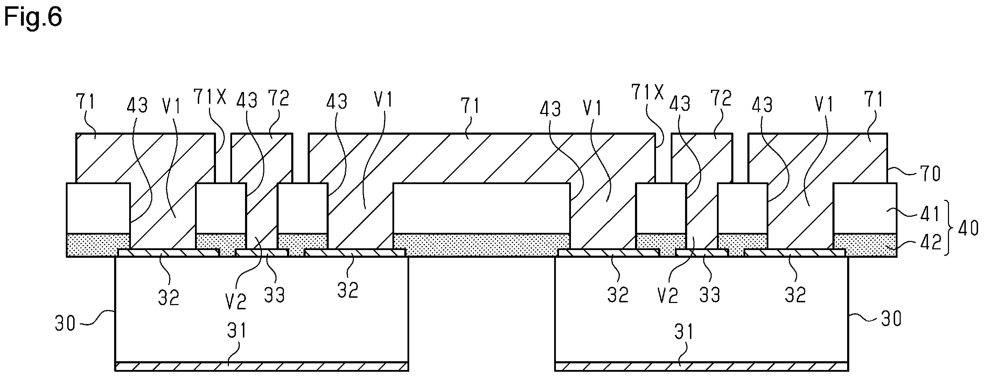

In the step illustrated in Fig. 6, the via wires V1 and V2 are formed in the through holes 43. Further, the wiring layer 70, which is electrically connected to the electrode pads 32 and 33 by the via wires V1 and V2, are formed on the upper surface of the first organic substrate 40. The wiring layer 70 includes the wiring pattern 71 and the wiring pattern 72. The via wires V1 and V2 and the wiring layer 70 may be formed, for example, through any of various wiring formation processes such as a semi-additive process.

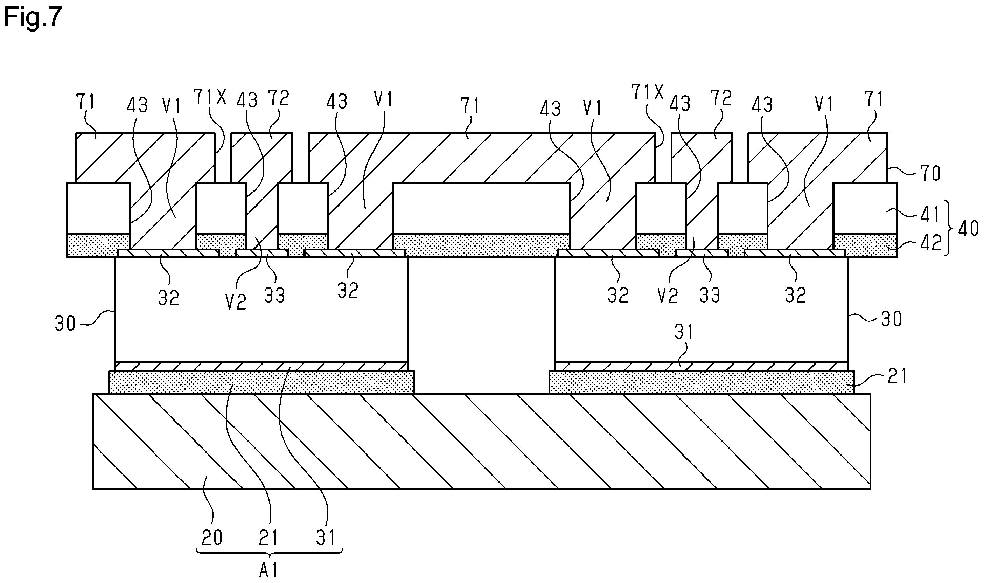

In the step illustrated in Fig. 7, the metal plate 20 is prepared. Then, the bonding portion 21 is formed on the upper surface of the metal plate 20. The bonding portion 21 may be formed, for example, by applying a paste of sintering material (sintering paste) through a printing process or a dispenser process. The sintering paste may be, for example, a silver sintering paste, which is which is prepared by dispersing silver particles in an organic solvent. The printing process may be, for example, a screen-printing process or a stencil printing process.

The semiconductor elements 30 are then placed on the upper surface of the bonding portion 21. The semiconductor elements 30 are placed on the upper surface of the bonding portion 21 so that the electrode pads 31, which are formed on the lower surfaces of the semiconductor elements 30, contact the upper surface of the bonding portion 21.

The bonding portion 21 is then heated. This sinters the bonding portion 21. As a result, the metal plate 20 is joined with the electrode pads 31 of the semiconductor elements 30 by the bonding portion 21. Thus, the semiconductor elements 30 are bonded to the upper surface of the metal plate 20 by the bonding portion 21.

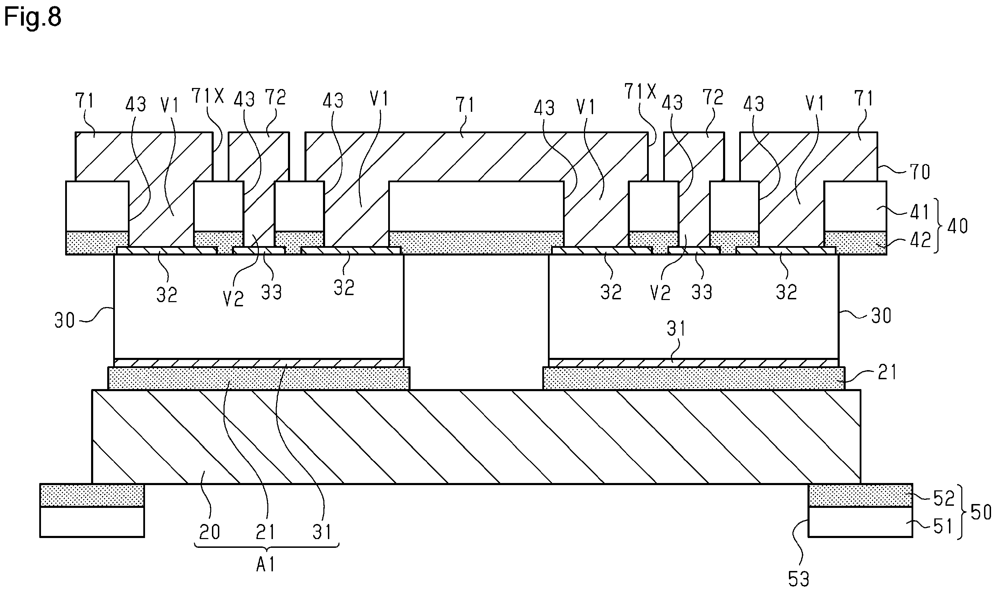

In the step of Fig. 8, the second organic substrate 50, which includes the open portion 53, is prepared. The second organic substrate 50 is structured so that the second adhesive layer 52 is stacked on the upper surface of the second substrate body 51. Then, the second organic substrate 50 is arranged on the lower surface of the metal plate 20. For example, the second adhesive layer 52 adheres the second organic substrate 50 to the lower surface of the metal plate 20. For example, a sheet of the second organic substrate 50 is laminated onto the lower surface of the metal plate 20 through thermal compression bonding. In this step, the metal plate 20 and the second organic substrate 50 are positioned so that the central part of the lower surface of the metal plate 20 is exposed from the open portion 53. Further, the metal plate 20 and the second organic substrate 50 are positioned so that the second organic substrate 50 projects outward from the outer side surfaces of the metal plate 20.

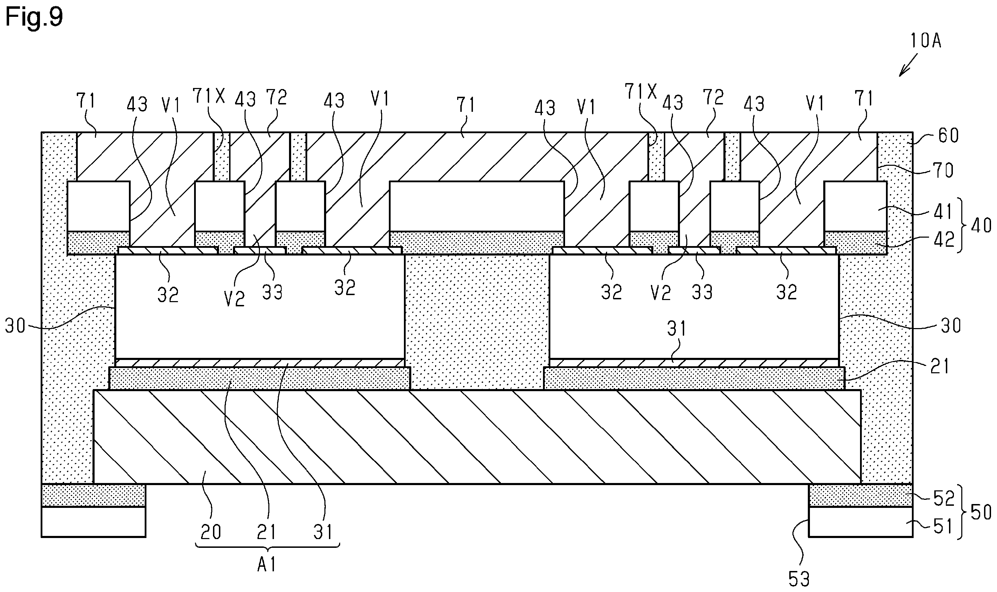

In the step illustrated in Fig. 9, the encapsulation resin 60 is formed encapsulating the semiconductor elements 30 between the first organic substrate 40 and the second organic substrate 50. The encapsulation resin 60 covers, for example, the outer side surfaces of the metal plate 20 and exposes the lower surface of the metal plate 20. The encapsulation resin 60, for example, entirely covers the first organic substrate 40. The encapsulation resin 60, for example, covers the upper surface of the first organic substrate 40 and covers the side surfaces of the wiring layer 70. The encapsulation resin 60 may be formed through, for example, a resin molding process. For example, when a thermosetting molding resin is used as the material of the encapsulation resin 60, the structural body illustrated in Fig. 8 is placed in a mold. Then, the mold is closed. Afterwards, a fluidized molding resin is filled into the mold through a mold gate (not illustrated) under a pressure of for example, about 3 MPa to 10 MPa. The molding resin is heated under a temperature of about 180°C and then cured to form the encapsulation resin 60. In this step, the open portion 71Y (refer to Fig. 2) of the wiring pattern 71 acts as a passage connecting a region in which the encapsulation resin 60 that covers the outer side surfaces of the wiring pattern 71 is formed and a region in which the encapsulation resin 60 filling the open portion 71X is formed. The molding resin moves through the open portion 71Y into the open portion 71X in a preferred manner. Upon completion of the encapsulation process, the structural body on which the encapsulation resin 60 has been formed is removed from the mold. The process for filling the mold with the molding resin may be, for example, transfer molding, compression molding, injection molding, or the like.

The semiconductor device 10A of the first embodiment is manufactured through the manufacturing steps described above. The semiconductor device 10A may be reversed upside-down for use or arranged at any angle.

The advantages of the first embodiment will now be described.

(1-1) The semiconductor device 10A includes the one or more semiconductor elements 30, each having a lower surface where the electrode pad 31 is formed and an upper surface where the electrode pad 32 is formed, and the first organic substrate 40, which is formed on the upper surfaces of the semiconductor elements 30. Further, the semiconductor device 10A includes the wiring layer 70, which is arranged on the upper surface of the first organic substrate 40 and electrically connected to the electrode pads 32, and the conductive layer A1, which is formed on the lower surfaces of the semiconductor elements 30. In the first embodiment, the conductive layer A1 includes the electrode pad 31, the bonding portion 21, and the metal plate 20 that are formed on the lower surfaces of the semiconductor elements 30. The semiconductor device 10A also includes the second organic substrate 50, which is arranged on the lower surface of the metal plate 20 of the conductive layer A1, and the encapsulation resin 60, which encapsulates the semiconductor elements 30 arranged between the first organic substrate 40 and the second organic substrate 50.

With this structure, the first organic substrate 40 is arranged on the upper surfaces of the semiconductor elements 30, and the second organic substrate 50 is arranged on the lower surface of the conductive layer A1, which is formed on the lower surfaces of the semiconductor elements 30. The semiconductor elements 30 are encapsulated by the encapsulation resin 60 between the first organic substrate 40 and the second organic substrate 50. The semiconductor elements 30 are encapsulated by the encapsulation resin 60 in a state sandwiched between two organic substrates, namely, the first organic substrate 40 and the second organic substrate 50. That is, the two substrates sandwiching the semiconductor elements 30 from opposites sides are both organic substrates. Thus, compared to when at least one of the two substrates sandwiching the semiconductor elements 30 from opposite sides is a ceramic substrate, the manufacturing cost of the semiconductor device 10A may be reduced.

(1-2) Further, the first organic substrate 40 and the second organic substrate 50 may be reduced in thickness more readily than ceramic substrates. Thus, compared to when at least one of the two substrates sandwiching the semiconductor elements 30 from opposite sides is a ceramic substrate, the semiconductor device 10A may be thinner.

(1-3) The first organic substrate 40 includes the first substrate body 41 and the first adhesive layer 42, which is formed on the lower surface of the first substrate body 41 and adhered to the upper surfaces of the semiconductor elements 30. The second organic substrate 50 includes the second substrate body 51 and the second adhesive layer 52, which is formed on the upper surface of the second substrate body 51 and adhered to the lower surface of the conductive layer A1. With this structure, the first adhesive layer 42 allows the first organic substrate 40 to be readily arranged on the upper surfaces of the semiconductor elements 30, and the second adhesive layer 52 allows the second organic substrate 50 to be readily arranged on the lower surface of the conductive layer A1.

(1-4) The first organic substrate 40 is formed from a resin having a high withstand voltage. The second organic substrate 50 is formed from a resin having a high withstand voltage. With this structure, the semiconductor elements 30 are sandwiched from opposite sides by two organic substrates having a high withstand voltage (dielectric withstand voltage), namely, the first organic substrate 40 and the second organic substrate 50. This increases the dielectric voltage of the semiconductor device 10A, while reducing the manufacturing cost of the semiconductor device 10A.

(1-5) The first organic substrate 40, which is formed from a resin having a high withstand voltage, covers at least the edges of the upper surface of each electrode pad 32. With this structure, the first organic substrate 40, which has a high withstand voltage, covers the edges of the upper surface of each electrode pad 32. Thus, leakage out of the edges of the electrode pad 32 is limited in a preferred manner. Further, since leakage is limited, the dielectric withstand voltage of the semiconductor device 10A may be increased.

(1-6) The second organic substrate 50, which is formed from a resin having a high withstand voltage, covers at least the outer edges of the lower surface of the metal plate 20, which forms the conductive layer A1. With this structure, the second organic substrate 50, which has a high withstand voltage, covers the outer edges of the lower surface of each electrode pad 31. Thus, leakage out of the edges of the electrode pad 31 is limited in a preferred manner. Further, since leakage is limited, the dielectric withstand voltage of the semiconductor device 10A may be increased.

(1-7) The first organic substrate 40 and the second organic substrate 50 allow the semiconductor device 10A to maintain a high dielectric withstand voltage. Thus, material having a low withstand voltage may be used as the material of the encapsulation resin 60. This increases the degree of freedom for selection of the material of the encapsulation resin 60. For example, the material of the encapsulation resin 60 may be selected from high-fluidity materials.

(1-8) The difference between the thermal expansion coefficient of the first organic substrate 40 and the thermal expansion coefficient of the second organic substrate 50 is less than the difference between the thermal expansion coefficient of the second organic substrate 50 and the thermal expansion coefficient of the semiconductor elements 30. Thus, for example, the difference in thermal expansion coefficient between the first organic substrate 40 and the second organic substrate 50 is less than the difference in thermal expansion coefficient between two substrates sandwiching the semiconductor elements 30 from opposite sides when one of the two substrates is a ceramic substrate. This balances the physical property values at opposite sides of the semiconductor elements 30, and limits warping or the like of the semiconductor device 10A that would be caused by thermal expansion and contraction.

(1-9) The second organic substrate 50 project outward from the outer side surfaces of the conductive layer A1. The encapsulation resin 60 is arranged on the upper surface of the second organic substrate 50 that is exposed from the conductive layer A1. The encapsulation resin 60 covers the outer side surfaces of the conductive layer A1. With this structure, the encapsulation resin 60 covers the outer side surfaces of the conductive layer A1. This limits leakage out of the outer side surfaces of the conductive layer A1.

(1-10) Further, the encapsulation resin 60 surrounds the edges of the metal plate 20. This limits separation of the metal plate 20 from the second organic substrate 50 or the like inside the encapsulation resin 60.

(1-11) The encapsulation resin 60 covers the outer side surfaces of the first organic substrate 40. With this structure, the encapsulation resin 60 surrounds the edges of the first organic substrate 40. This limits separation of the first organic substrate 40 from the semiconductor elements 30 or the like inside the encapsulation resin 60.

(1-12) The bonding portion 21 joins the metal plate 20 and the electrode pads 31 of the semiconductor elements 30. The metal plate 20 increases the heat capacity of the semiconductor device 10A. This limits increases in the temperature of the semiconductor device 10A when it is activated.

(1-13) Further, the metal plate 20 increases the rigidity of the entire semiconductor device 10A. This limits warping or the like of the semiconductor device 10A in a preferred manner.

(1-14) The second organic substrate 50 includes the open portion 53, which extends through the second organic substrate 50 in the thickness direction and partially exposes the lower surface of the metal plate 20. This structure facilitates electrical connection of the metal plate 20, through the open portion 53, to a mounting board such as a motherboard.

### Second Embodiment

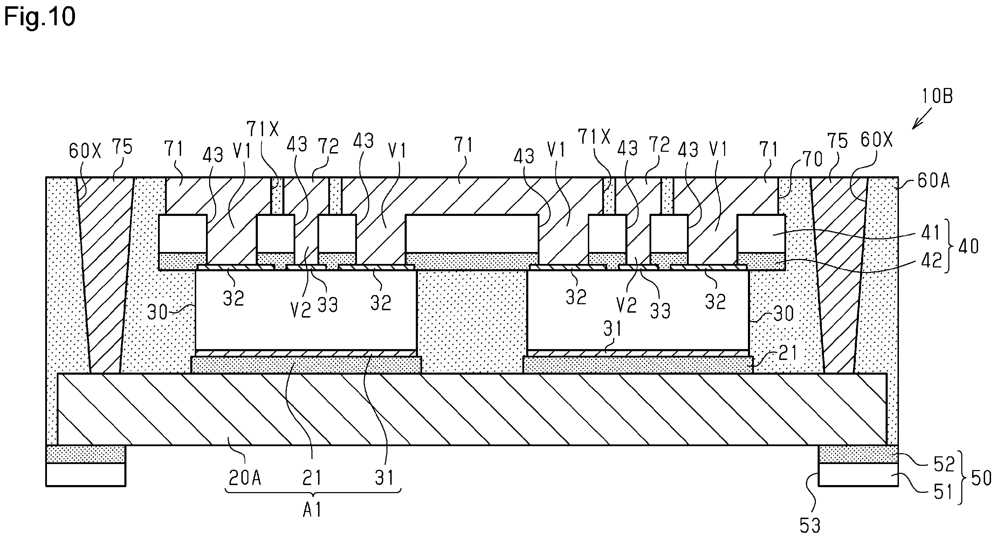

A second embodiment will now be described with reference to Figs. 10 to 18. The description hereafter will focus on differences from the first embodiment. The same reference numerals are given to those components that are the same as the corresponding components illustrated in Figs. 1 to 9. Such components will not be described in detail.

### Overall Structure of Semiconductor Device 10B

The overall structure of a semiconductor device 10B will now be described with reference to Fig. 10.

The semiconductor device 10B includes a metal plate 20A, the bonding portion 21, the one or more (four in the second embodiment) semiconductor elements 30, the first organic substrate 40, and the second organic substrate 50. The semiconductor device 10B includes an encapsulation resin 60A, which encapsulates the semiconductor elements 30, the wiring layer 70, and through-electrodes 75, which extend through the encapsulation resin 60A in the thickness direction. The semiconductor device 10B incorporates the semiconductor elements 30 between the first organic substrate 40 and the second organic substrate 50.

### Structure of Metal Plate 20A

The metal plate 20A is flat. The metal plate 20A may be formed, for example, from a metal, such as aluminum, copper, iron (Fe), or molybdenum (Mo), or from an alloy including at least one of these metals. In the second embodiment, the metal plate 20A is a copper plate.

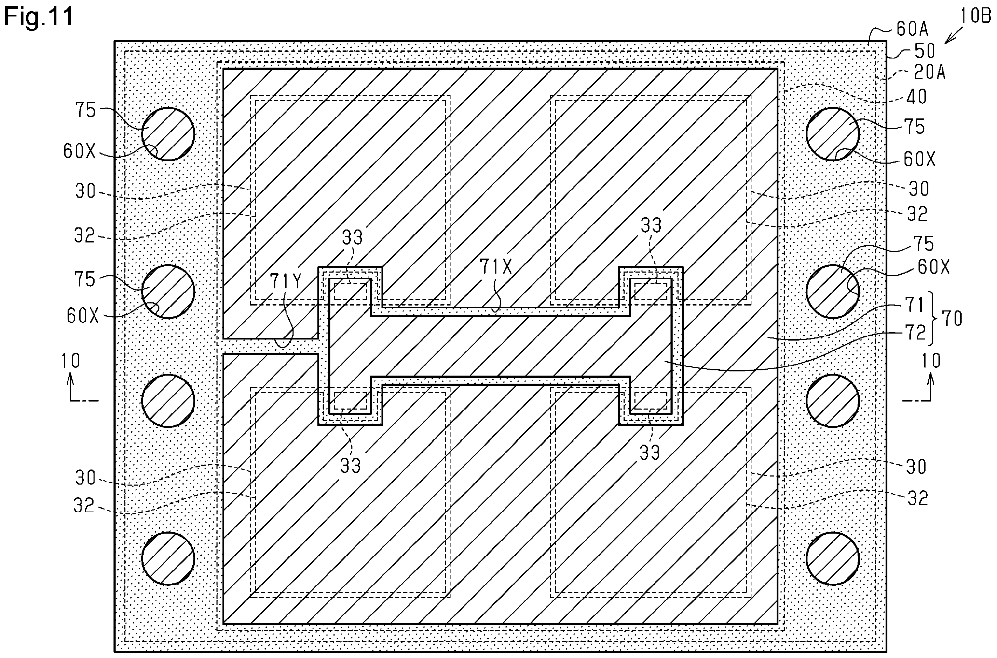

Referring to Fig. 11, the metal plate 20A has, for example, a quadrilateral planar shape. The metal plate 20A is not limited to a quadrilateral planar shape and may have any planar shape. The metal plate 20A has, for example, a larger planar size than the first organic substrate 40. The metal plate 20A has, for example, a slightly larger planar size than the first organic substrate 40. The metal plate 20A entirely overlaps, for example, the first organic substrate 40 in plan view.

Referring to Fig. 10, in the semiconductor device 10B of the second embodiment, the metal plate 20A, the bonding portion 21, and the electrode pad 31 form the conductive layer A1.

### Structure of Second Organic Substrate 50

The second organic substrate 50 is arranged on the lower surface of the metal plate 20A. The second organic substrate 50 covers at least the outer edges of the lower surface of the metal plate 20A. The second organic substrate 50 covers, for example, all the edges of the lower surface of the metal plate 20A. The second organic substrate 50 projects outward from, for example, the outer side surfaces of the metal plate 20A.

### Structure of Encapsulation Resin 60A

The encapsulation resin 60A encapsulates, for example, the semiconductor elements 30, which are arranged between the first organic substrate 40 and the second organic substrate 50. The encapsulation resin 60A encapsulates, for example, the plurality of (in this case, four) semiconductor elements 30 together. The encapsulation resin 60A covers, for example, the side surfaces of each semiconductor element 30, the upper surface of the bonding portion 21 exposed from each semiconductor element 30, and the side surfaces of the bonding portion 21. The encapsulation resin 60A entirely covers, for example, the upper surface of the metal plate 20A exposed from the bonding portion 21.

The encapsulation resin 60A is arranged on, for example, the upper surface of the second organic substrate 50 that is exposed from the metal plate 20A. The encapsulation resin 60A entirely covers, for example, the upper surface of the second organic substrate 50 that is exposed from the metal plate 20A. The encapsulation resin 60A exposes the outer side surfaces of the second organic substrate 50. The outer side surfaces of the encapsulation resin 60A are, for example, flush with the outer side surfaces of the second organic substrate 50. The encapsulation resin 60A entirely covers, for example, the outer side surfaces of the metal plate 20A. The encapsulation resin 60A covers, for example, all the outer side surfaces of the metal plate 20A. The encapsulation resin 60A exposes, for example, the lower surface of the metal plate 20A.

The encapsulation resin 60A entirely covers, for example, the outer side surfaces of the first organic substrate 40. The encapsulation resin 60A covers, for example, all the outer side surfaces of the first organic substrate 40. The encapsulation resin 60A entirely covers, for example, the lower surface of the first organic substrate 40 exposed from the semiconductor elements 30.

The encapsulation resin 60A entirely covers, for example, the upper surface of the first organic substrate 40 exposed from the wiring layer 70. The encapsulation resin 60A entirely covers, for example, the side surfaces of the wiring layer 70. The encapsulation resin 60A exposes, for example, the upper surface of the wiring layer 70. The upper surface of the encapsulation resin 60A is flush with, for example, the upper surface of the wiring layer 70.

The material of the encapsulation resin 60A may be, for example, a non-photosensitive insulative resin of which the main component is a thermosetting resin. The material of the encapsulation resin 60A may be, for example, an insulative resin such as epoxy resin or polyimide resin, or a resin material prepared by mixing such resins with a filler such as silica or alumina. The encapsulation resin 60A may be, for example, a molding resin. The encapsulation resin 60A may have a thermal expansion coefficient of, for example, about 5 ppm/°C to 18 ppm/°C.

The encapsulation resin 60A includes one or more (eight in the second embodiment) through holes 60X extending through the encapsulation resin 60A and partially exposing the upper surface of the metal plate 20A. The through holes 60X are, for example, located in a peripheral region located outward from the first organic substrate 40. Each through hole 60X is, for example, tapered so that its opening width (opening diameter) decreases from the upper side (upper surface of the encapsulation resin 60A) toward the lower side (metal plate 20A) as viewed in Fig. 10. For example, each through hole 60X has the form of a reversed truncated cone so that the opening diameter of its lower end is smaller than the opening diameter of its upper end.

Referring to Fig. 11, the through holes 60X are arranged next to one another in, for example, the vertical direction as viewed in Fig. 11. The through holes 60X are arranged, for example, outward from the first organic substrate 40 in the lateral direction as viewed in Fig. 11. The through holes 60X are arranged, for example, at the two lateral sides of the first organic substrate 40 in the lateral direction as viewed in Fig. 11.

### Structure of Through-Electrodes 75

Referring to Fig. 10, the through-electrodes 75 are formed inside the through holes 60X. The through-electrodes 75, for example, fill the through holes 60X, respectively. The through-electrodes 75 extend through the encapsulation resin 60A in the thickness direction. The upper end surface of each through-electrode 75 is exposed from the encapsulation resin 60A. The upper end surface of each through-electrode 75 is, for example, flush with the upper surface of the encapsulation resin 60A. The upper end surface of each through-electrode 75, for example, extends along the same plane as the upper surface of the wiring layer 70.

The through-electrodes 75 are electrically connected to the metal plate 20A. The through-electrodes 75 are electrically connected to the electrode pads 31 of the semiconductor elements 30 by the metal plate 20A and the bonding portion 21. In other words, the electrode pads 31 connect to the upper surface of the encapsulation resin 60A through the bonding portion 21, the metal plate 20A, and the through-electrodes 75. This connects every one of the electrode pads 31, the electrode pads 32, and the electrode pads 33 to the upper surface of the encapsulation resin 60A.

### Method for Manufacturing Semiconductor Device 10B

A method for manufacturing the semiconductor device 10B will now be described. To simplify illustration, elements that will consequently become the final elements of the semiconductor device 10B are given the same reference characters as the final elements.

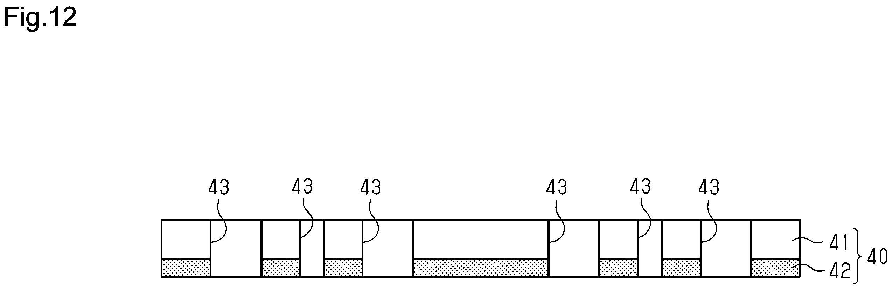

First, in the step illustrated in Fig. 12, the first organic substrate 40, which includes the through holes 43, is formed in the same manner as the steps illustrated in Figs. 3 and 4.

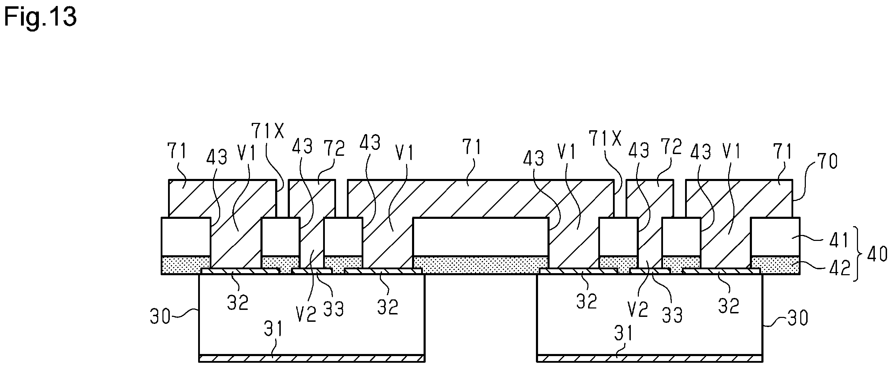

In the step illustrated in Fig. 13, the semiconductor elements 30, which includes the electrode pads 31, 32, and 33, are prepared. Then, the first organic substrate 40 is arranged on the upper surfaces of the semiconductor elements 30in the same manner as the step illustrated in Fig. 5.

Further, in the same manner as the step illustrated in Fig. 6, the via wires V1 and V2 are formed in the through holes 43, and the wiring layer 70, which is electrically connected to the electrode pads 32 and 33 by the via wires V1 and V2, is formed on the upper surface of the first organic substrate 40.

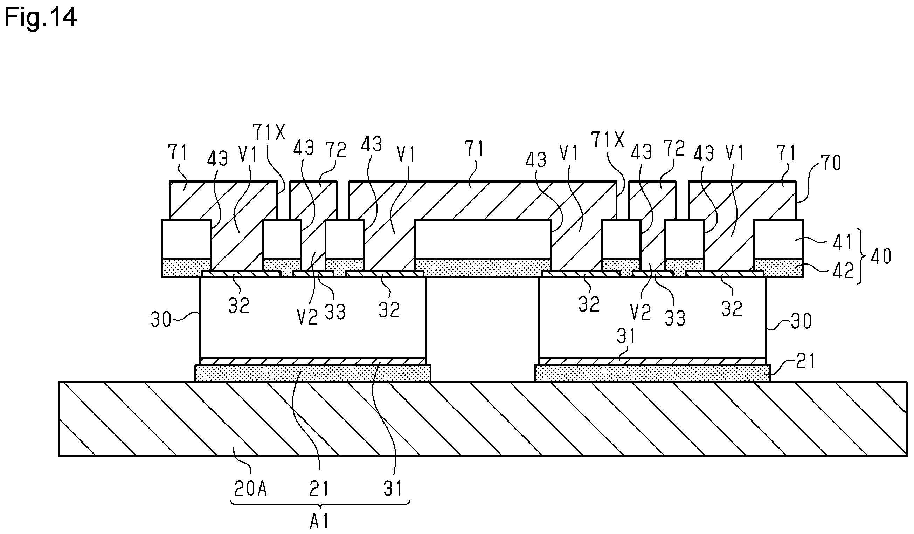

In the step illustrated in Fig. 14, the metal plate 20A is prepared. Further, in the same manner as the step illustrated in Fig. 7, the bonding portion 21 is formed on the upper surface of the metal plate 20A, and the semiconductor elements 30 are then joined with the upper surface of the bonding portion 21.

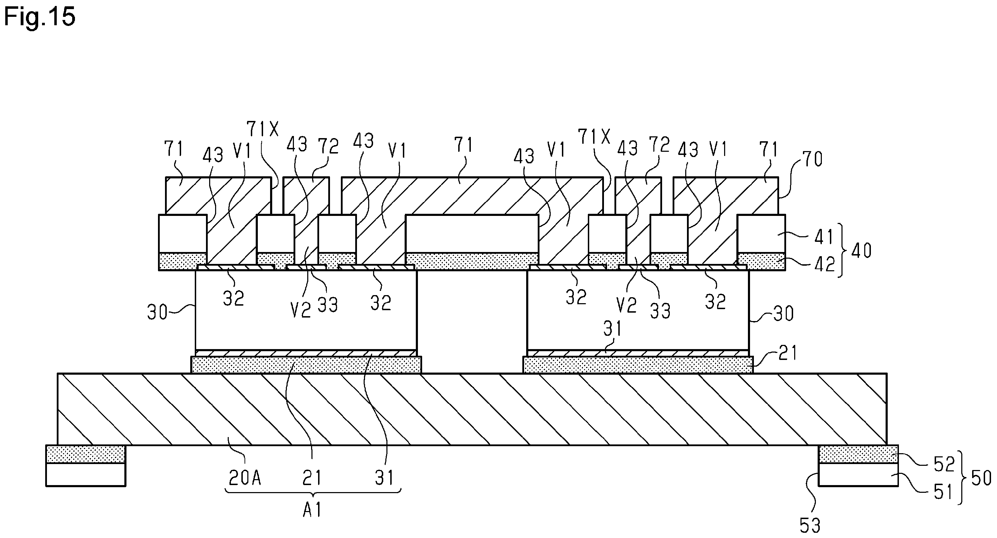

In the step illustrated in Fig. 15, the second organic substrate 50, which includes the open portion 53, is prepared. Then, in the same manner as the step illustrated in Fig. 8, the second organic substrate 50 is arranged on the lower surface of the metal plate 20A.

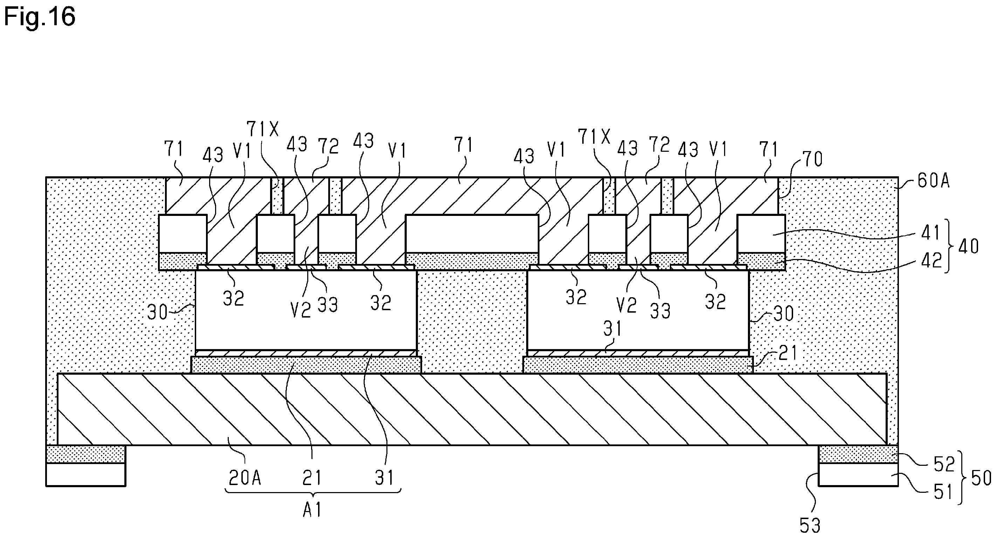

In the step illustrated in Fig. 16, the encapsulation resin 60A, which encapsulates the semiconductor elements 30 between the first organic substrate 40 and the second organic substrate 50, is formed in the same manner as the step illustrated in Fig. 9. The encapsulation resin 60A covers, for example, the outer side surfaces of the metal plate 20A and exposes the lower surface of the metal plate 20A. The encapsulation resin 60A entirely covers, for example, the first organic substrate 40. The encapsulation resin 60A, for example, covers the upper surface of the first organic substrate 40 and covers the side surfaces of the wiring layer 70.

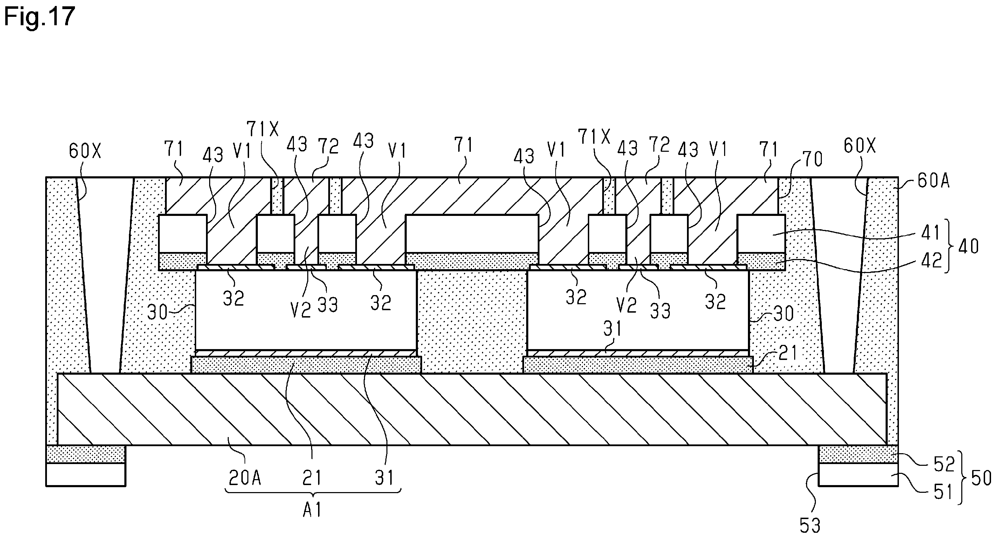

In the step illustrated in Fig. 17, the through holes 60X are formed extending through the encapsulation resin 60A in the thickness direction and partially exposing the upper surface of the metal plate 20A. The through holes 60X may be formed, for example, through laser processing using a CO₂ laser or a UV-YAG laser. When forming the through holes 60X through laser processing, a desmearing process is performed to remove smeared resin from the surface of the metal plate 20A that is exposed at the bottom portions of the through holes 60X.

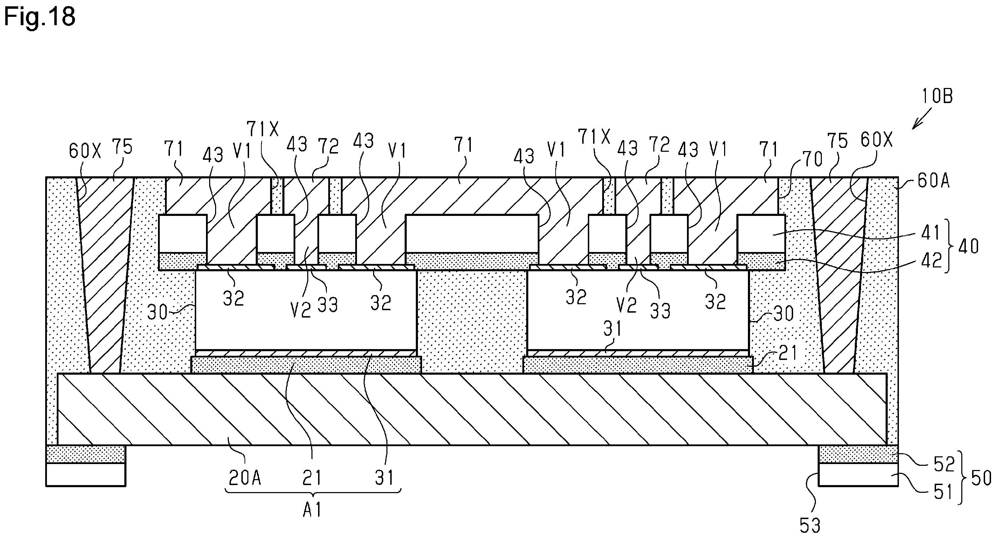

In the step illustrated in Fig. 18, the through-electrodes 75 are formed inside the through holes 60X. The through-electrodes 75 fill the through holes 60X. The through-electrodes 75 are formed, for example, through screen printing that fills the through holes 60X with a conductive paste. The conductive paste may be, for example, a solder paste or a copper paste.

The semiconductor device 10B of the second embodiment is manufactured through the manufacturing steps described above. The semiconductor device 10B may be reversed upside-down for use or arranged at any angle.

In addition to advantages (1-1) to (1-14) of the first embodiment, the second embodiment has the advantage described below.

(2-1) The metal plate 20A projects outward from the outer side surfaces of the first organic substrate 40. The semiconductor device 10B includes the through holes 60X, which extend through the encapsulation resin 60A in the thickness direction and partially expose the upper surface of the metal plate 20A, and the through-electrodes 75, which fill the through holes 60X and are electrically connected to the metal plate 20A.

With this structure, the through-electrodes 75 are electrically connected to the electrode pads 31, which are formed on the lower surfaces of the semiconductor elements 30, by the metal plate 20A and the bonding portion 21. Thus, the electrode pads 31 connect to the upper surface of the encapsulation resin 60A through the bonding portion 21, the metal plate 20A, and the through-electrodes 75. This connects every one of the electrode pads 31, the electrode pads 32, and the electrode pads 33 to the upper surface of the encapsulation resin 60A.

### Third Embodiment

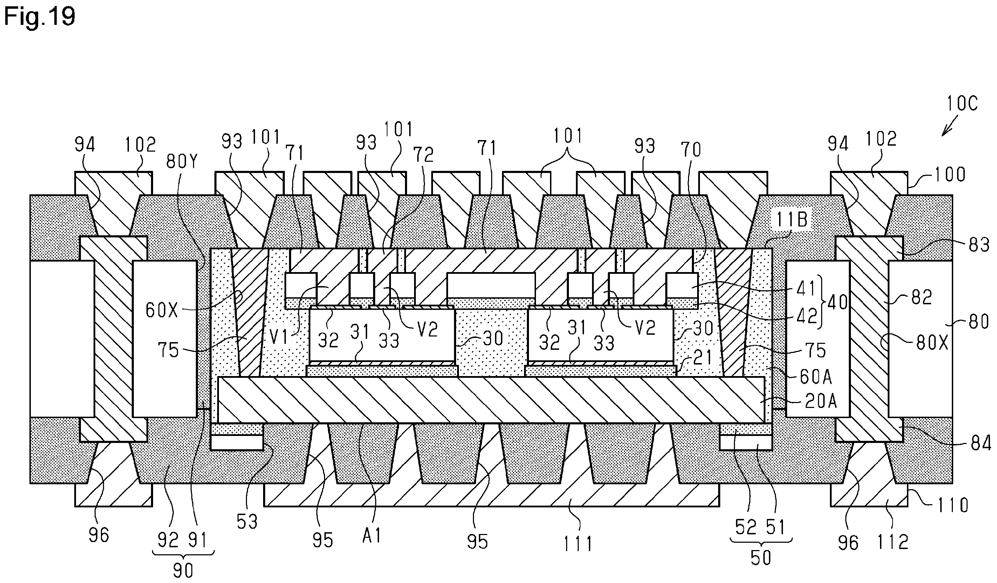

A third embodiment will now be described with reference to Figs. 19 to 27. The description hereafter will focus on differences from the second embodiment. The same reference numerals are given to those components that are the same as the corresponding components illustrated in Figs. 1 to 18. Such components will not be described in detail.

### Overall Structure of Semiconductor Device 10C

The overall structure of a semiconductor device 10C will now be described with reference to Fig. 19.

The semiconductor device 10C includes a substrate 80, a structural body 11B, a resin layer 90, a wiring layer 100, and a wiring layer 110.

The substrate 80 is arranged in, for example, the central part of the semiconductor device 10C in the thickness direction. The substrate 80 is, for example, a core substrate. The substrate 80 may be, for example, a glass epoxy substrate formed by impregnating a glass cloth (glass woven cloth), which is reinforcing material, with an insulative thermosetting resin, the main component of which is an epoxy resin, and then curing the resin. The reinforcing material is not limited to a glass cloth and may be, for example, a glass non-woven cloth, an aramid woven cloth, an aramid non-woven cloth, a liquid crystal polymer (LCP) woven cloth, or an LCP non-woven cloth. The insulative thermosetting resin is not limited to epoxy resin and may be, for example, a resin material such as polyimide resin or cyanate resin. The material of the substrate 80 may be an insulative resin that does not contain a reinforcing material.

The substrate 80 includes through holes 80X extending through the substrate 80 in the thickness direction. Through-electrodes 82 extending through the substrate 80 in the thickness direction are formed in the through holes 80X. The through-electrodes 82, for example, fill the through holes 80X, respectively.

A wiring layer 83 is formed on the upper surface of the substrate 80. The wiring layer 83 is electrically connected to the through-electrodes 82. The wiring layer 83 may have a thickness of, for example, about 35 µm to 50 µm.

A wiring layer 84 is formed on the lower surface of the substrate 80. The wiring layer 84 is electrically connected to the wiring layer 83 by the through-electrodes 82. The wiring layer 84 may have a thickness of, for example, about 35 µm to 50 µm. The material of the through-electrodes 82 and the wiring layers 83 and 84 may be, for example, copper or copper alloy.

The substrate 80 includes at least one (one in the third embodiment) accommodation hole 80Y that accommodates the structural body 11B. The accommodation hole 80Y extends through the substrate 80 in the thickness direction. The accommodation hole 80Y is arranged, for example, in the central part of the substrate 80. The accommodation hole 80Y is sized to accommodate the structural body 11B. In this disclosure, the substrate 80 may also be referred to as an accommodation substrate.

The accommodation hole 80Y has, for example, a quadrilateral planar shape that is similar to the planar shape of the structural body 11B. The accommodation hole 80Y has, for example, a larger planar size than the structural body 11B. The accommodation hole 80Y has, for example, a slightly larger planar size than the structural body 11B.

### Structural Body 11B

The structural body 11B has, for example, a structure similar to that of the semiconductor device 10B illustrated in Fig. 10. The structural body 11B includes the metal plate 20A, the bonding portion 21, the one or more semiconductor elements 30, the first organic substrate 40, the second organic substrate 50, the encapsulation resin 60A, the wiring layer 70, and the through-electrodes 75. In the structural body 11B, the semiconductor elements 30 are incorporated between the first organic substrate 40 and the second organic substrate 50.

### Structure of Resin Layer 90

The resin layer 90 fills the accommodation hole 80Y. The resin layer 90 entirely covers the structural body 11B. The resin layer 90 entirely covers the outer side surfaces of the structural body 11B. The resin layer 90 also covers the upper surface of the structural body 11B and the lower surface of the structural body 11B. The resin layer 90 covers, for example, the upper surface of the substrate 80 and the lower surface of the substrate 80.

The resin layer 90 includes, for example, a resin layer 91 and a resin layer 92. The resin layers 91 and 92 may be formed from, for example, an insulative resin such as an epoxy resin or a polyimide resin. The material of the resin layer 91 may be the same as or differ from the material of the resin layer 92.

The resin layer 91 partially covers the outer side surfaces of the structural body 11B and covers the upper surface of the structural body 11B. The resin layer 91 covers the upper surface of the substrate 80 and covers the upper surface and side surfaces of the wiring layer 83.

The resin layer 92 covers the outer side surfaces of the structural body 11B, that are exposed from the resin layer 91 and covers the lower surface of the structural body 11B. The resin layer 92, for example, fills the open portion 53 of the second organic substrate 50 of the structural body 11B. The resin layer 92 covers the lower surface of the substrate 80 and covers the lower surface and side surfaces of the wiring layer 84.

The resin layer 91 includes through holes 93 and 94 extending through the resin layer 91 in the thickness direction. The through holes 93, for example, partially expose the upper surface of the wiring layer 70 or the upper surfaces of the through-electrodes 75. The through holes 94, for example, partially expose the upper surface of the wiring layer 83. Each of the through holes 93 and 94 is, for example, tapered so that its opening width (opening diameter) decreases from the upper side (upper surface of resin layer 91) toward the lower side as viewed in Fig. 19. For example, each of the through holes 93 and 94 has the form of a reversed truncated cone so that the opening diameter of its lower end is smaller than the opening diameter of its upper end.

The resin layer 92 includes through holes 95 and 96 extending through the resin layer 92 in the thickness direction. The through holes 95, for example, partially expose the lower surface of the metal plate 20A. The through holes 96, for example, partially expose the lower surface of the wiring layer 84. Each of the through holes 95 and 96 is, for example, tapered so that its opening width (opening diameter) decreases from the lower side (lower surface of the resin layer 92) toward the upper side as viewed in Fig. 19. For example, each of the through holes 95 and 96 has the form of a truncated cone so that the opening diameter of its upper end is smaller than the opening diameter of its lower end.

### Structure of Wiring Layer 100

The wiring layer 100 is formed on the upper surface of the resin layer 91. The wiring layer 100 includes one or more wiring patterns 101 and one or more wiring patterns 102.

The wiring patterns 101 and 102 may be formed from, for example, copper or copper alloy. When necessary, a surface-processed layer is formed on the surfaces (upper surfaces and side surfaces or only upper surfaces) of the wiring patterns 101 and 102. Examples of the surface-processed layer include a metal layer such as a Au layer, a Ni layer/Au layer, and a Ni layer/ Pd layer/Au layer. The wiring patterns 101 and 102 may have a thickness of, for example, about 50 µm to 200 µm.

Some of the wiring patterns 101 are, for example, electrically connected to the wiring pattern 71 by via wires formed in the through holes 93, which partially expose the upper surface of the wiring pattern 71. Some of the wiring patterns 101 are, for example, electrically connected to the wiring pattern 72 by via wires formed in the through holes 93, which partially expose the upper surface of the wiring pattern 72. Some of the wiring patterns 101 are, for example, electrically connected to the through-electrodes 75 by via wires formed in the through holes 93, which partially expose the upper surfaces of the through-electrodes 75. The wiring patterns 101 are, for example, formed integrally with the via wires that fill the through holes 93. The wiring patterns 102 are electrically connected to the wiring layer 83 by via wires formed in the through holes 94. The wiring patterns 102 are, for example, formed integrally with the via wires that fill the through holes 94.

### Structure of Wiring Layer 110

The wiring layer 110 is formed on the lower surface of the resin layer 92. The wiring layer 110 includes at least one wiring pattern 111 and at least one wiring pattern 112.

The wiring patterns 111 and 112 may be formed from, for example, copper or copper alloy. When necessary, a surface-processed layer is formed on the surfaces (lower surfaces and side surfaces or only lower surfaces) of the wiring patterns 111 and 112. Examples of the surface-processed layer include a metal layer such as a Au layer, a Ni layer/Au layer, and a Ni layer/ Pd layer/Au layer. The wiring patterns 111 and 112 may have a thickness of, for example, about 50 µm to 200 µm.

The wiring pattern 111 is, for example, electrically connected to the metal plate 20A by via wires formed in the through holes 95 The wiring pattern 111 is, for example, formed integrally with the via wires that fill the through holes 95. The wiring pattern 111 is, for example, formed as a solid plane. The wiring pattern 112 is electrically connected to the wiring layer 84 by via wires formed in the through holes 96. The wiring pattern 112 is, for example, formed integrally with the via wires that fill the through holes 96.

### Method for Manufacturing Semiconductor Device 10C

A method for manufacturing the semiconductor device 10C will now be described. To simplify illustration, elements that will consequently become the final elements of the semiconductor device 10C are given the same reference characters as the final elements.

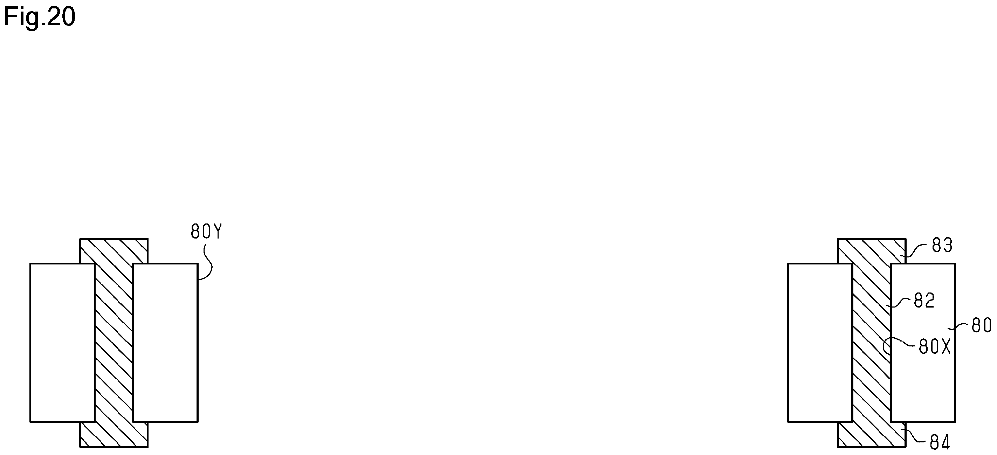

First, in the step illustrated in Fig. 20, a known technique is used to prepare a structural body including the substrate 80, the through-electrodes 82 extending through the substrate 80 in the thickness direction, the wiring layer 83 formed on the upper surface of the substrate 80, and the wiring layer 84 formed on the lower surface of the substrate 80. Then, the accommodation hole 80Y, which extends through the substrate 80 in the thickness direction, is formed in the substrate 80. The accommodation hole 80Y may be formed, for example, through laser processing, router processing, metalworking using a mold, mechanical drilling, or the like.

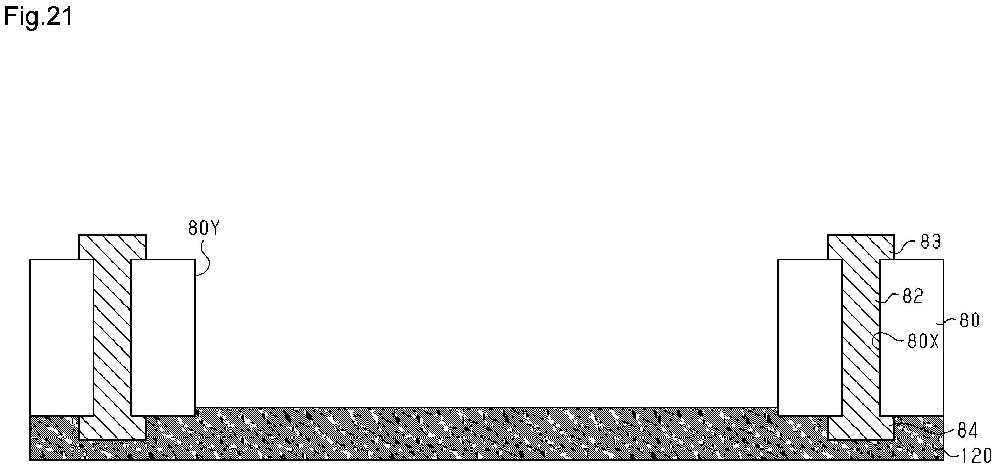

In the step illustrated in Fig. 21, an adhesive film 120 is applied to the lower surface of the substrate 80. The adhesive film 120, for example, extends around the wiring layer 84. The adhesive film 120, for example, covers the lower surface and side surfaces of the wiring layer 84. The adhesive film 120, for example, extends around part of the substrate 80. The adhesive film 120, for example, partially covers the wall surfaces of the accommodation hole 80Y of the substrate 80. In this state, the upper surface of the adhesive film 120 is partially exposed from the accommodation hole 80Y as illustrated in Fig. 21. The adhesive film 120 may be formed from, for example, a material having superior chemical resistance or superior heat resistance. The adhesive film 120 may be, for example, a polyethylene terephthalate (PET) film provided with an adhesive layer.

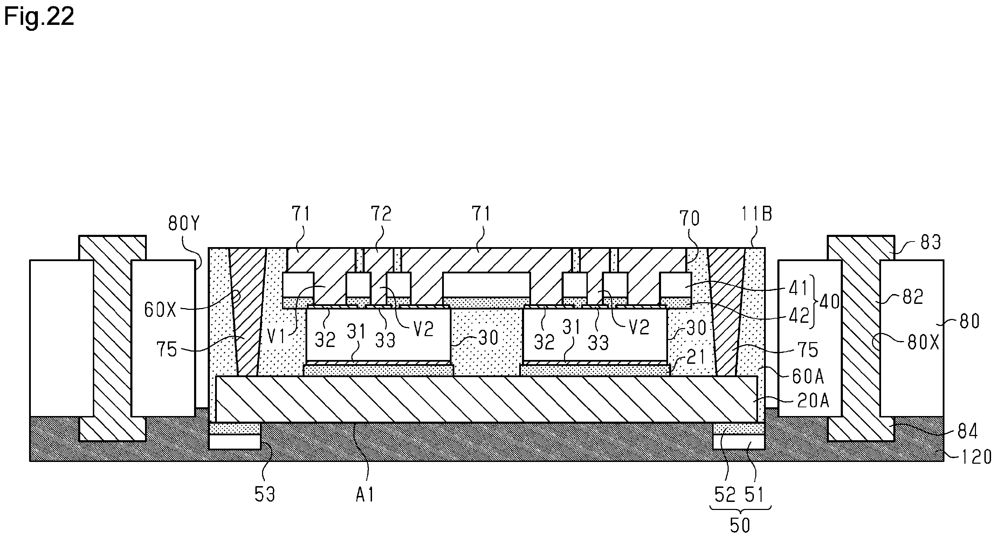

In the step illustrated in Fig. 22, the structural body 11B is prepared including the metal plate 20A, the semiconductor elements 30, the first organic substrate 40, the second organic substrate 50, the encapsulation resin 60A, the wiring layer 70, and the through-electrodes 75. The structural body 11B may be manufactured, for example, through the steps illustrated in Figs. 12 to 18. Then, a mounter is used to mount the structural body 11B on the adhesive film 120 in the accommodation hole 80Y. The structural body 11B is mounted on the adhesive film 120 so that a lower part of the structural body 11B is embedded in the adhesive film 120. For example, the structural body 11B is mounted on the adhesive film 120 so that the second organic substrate 50 of the structural body 11B is embedded in the adhesive film 120.

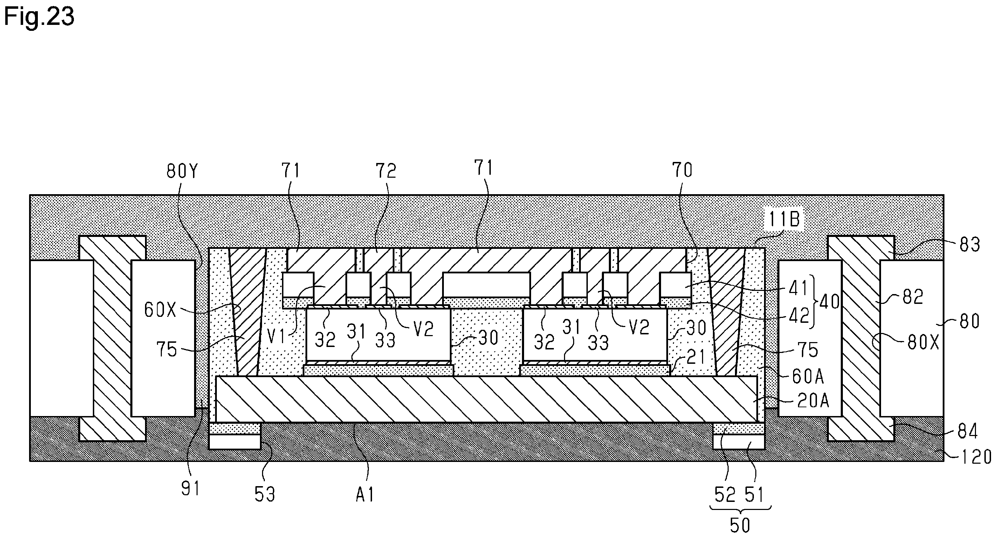

In the step illustrated in Fig. 23, the resin layer 91 is formed filling the accommodation hole 80Y exposed from the adhesive film 120 and covering the upper surface of the adhesive film 120, the upper surface of the substrate 80, and the upper surface and side surfaces of the wiring layer 83. Thus, the resin layer 91 entirely covers the wall surfaces of the accommodation hole 80Y that are exposed from the adhesive film 120 and the surfaces of the structural body 11B that are exposed from the adhesive film 120. Further, the resin layer 91 entirely covers the upper surface of the substrate 80, the upper surface of the wiring layer 83, and the side surfaces of the wiring layer 83. That is, as illustrated in Fig. 23, the resin layer 91 entirely covers the surface at the side opposite to the surface to which the adhesive film 120 is applied.

The resin layer 91 is formed, for example, by stacking a sheet of an insulative resin in a semi-cured stage (B-stage) onto the upper surface of the wiring layer 83 to close the accommodation hole 80Y. The insulative resin sheet is heated and pressurized under a de-pressurized atmosphere (e.g., in a vacuum) to fill the accommodation hole 80Y with insulative resin, which is then cured. The insulative resin may be, for example, an epoxy resin or a polyimide resin.

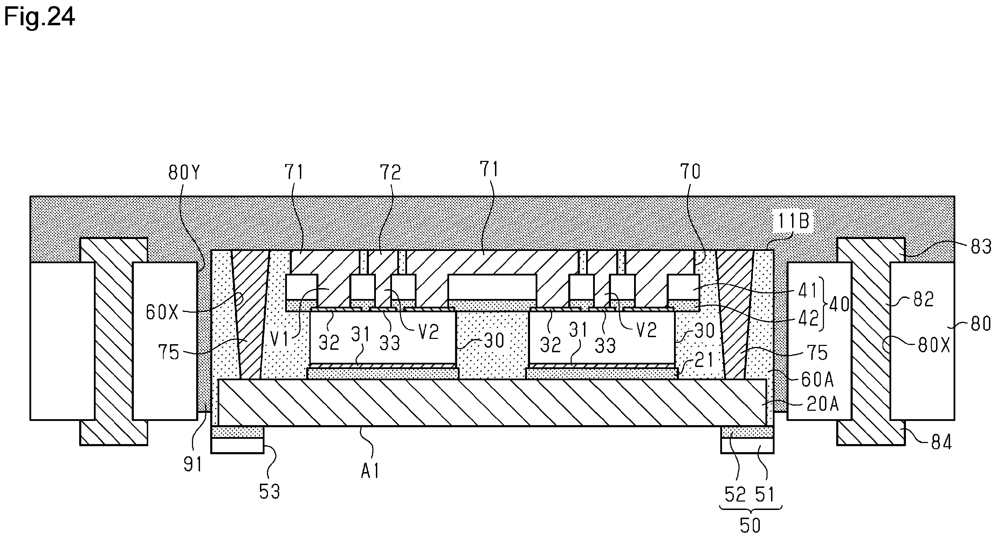

In the step illustrated in Fig. 24, the adhesive film 120 illustrated in Fig. 23 is removed. This exposes the part that was embedded in the adhesive film 120, namely, the lower surface of the substrate 80, the lower surface and side surfaces of the wiring layer 84, and the lower part of the structural body 11B.

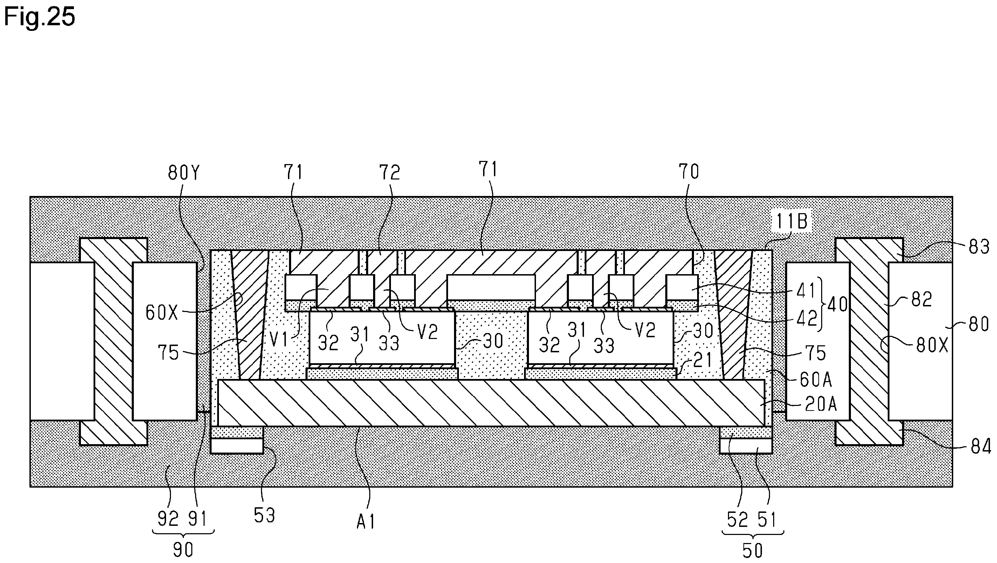

In the step illustrated in Fig. 25, the resin layer 92 is formed filling the accommodation hole 80Y exposed from the resin layer 91, the lower surface of the substrate 80, and the lower surface and side surfaces of the wiring layer 84. Thus, the resin layer 92 entirely covers the wall surfaces of the accommodation hole 80Y that are exposed from the resin layer 91 and the surfaces of the structural body 11B that are exposed from the resin layer 91. Further, the resin layer 92 entirely covers the lower surface of the substrate 80, the lower surface of the wiring layer 84, and the side surfaces of the wiring layer 84.

The resin layer 92 is formed, for example, by stacking a sheet of an insulative resin in a semi-cured stage (B-stage) onto the lower surface of the wiring layer 84 to close the accommodation hole 80Y. The insulative resin sheet is then heated and pressurized under a de-pressurized atmosphere (e.g., in a vacuum) to fill the accommodation hole 80Y with the insulative resin, which is then cured. The insulative resin may be, for example, an epoxy resin or a polyimide resin.

The manufacturing steps described above form the resin layer 91, the resin layer 92, and the resin layer 90, which encapsulates the structural body 11B.

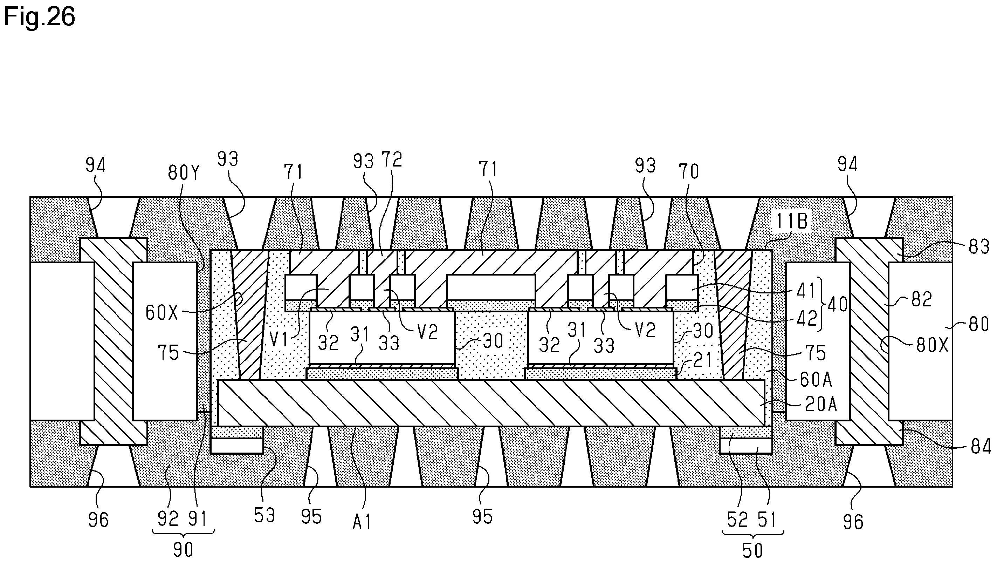

In the step illustrated in Fig. 26, the through holes 93 are formed in the resin layer 91 at give locations to partially expose the upper surfaces of the wiring layer 70 and the through-electrodes 75. The through holes 94 are formed in the resin layer 91 at given locations to partially expose the upper surface of the wiring layer 83. Further, in this step, the through holes 95 are formed in the resin layer 92 at given locations to partially expose the lower surface of the metal plate 20A. The through holes 96 are formed in the resin layer 92 at given locations to partially expose the lower surface of the wiring layer 84. The through holes 93 94, 95, and 96 may be formed, for example, through laser processing using a CO₂ laser or a UV-YAG laser. When forming the through holes 93 to 96 through laser processing, a desmearing process is performed to remove smeared resin from the wiring layers 70, 83, and 84 that are exposed at the bottom portions of the through holes 93 to 96 and from the exposed surfaces of the through-electrodes 75 and the metal plate 20A.

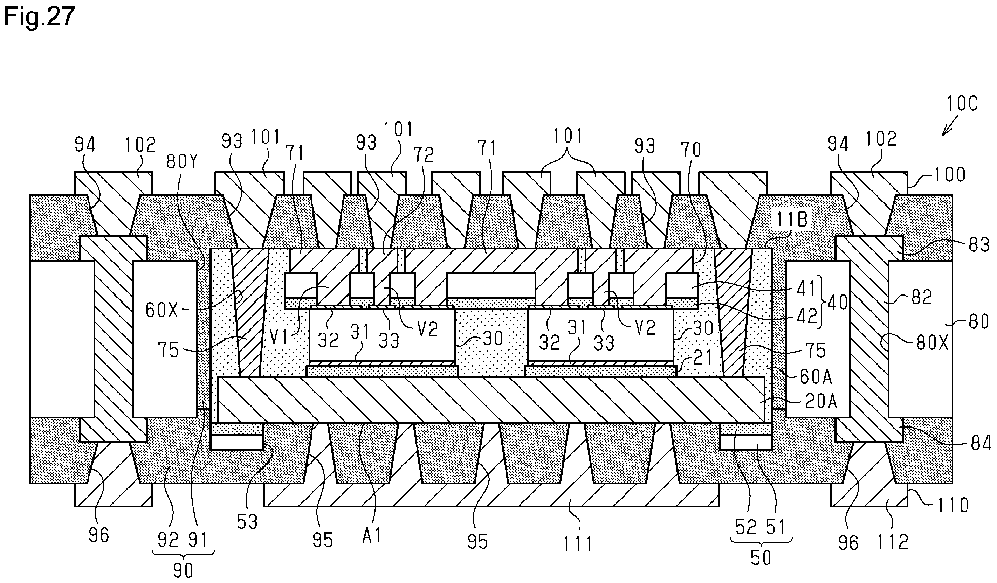

In the step illustrated in Fig. 27, via wires are formed filling the through holes 93. Further, the wiring patterns 101, which are electrically connected to the wiring layer 70 or the through-electrodes 75 by the via wires, are formed on the upper surface of the resin layer 91. Via wires are also formed filling the through holes 94. Further, the wiring patterns 102, which are electrically connected to the wiring layer 83 by the via wires, are formed on the upper surface of the resin layer 91. Consequently, the wiring layer 100, which includes the wiring patterns 101 and the wiring patterns 102, is formed on the upper surface of the resin layer 91. In this step, via wires are formed filling the through holes 95. Further, the wiring pattern 111, which is electrically connected to the metal plate 20A by the via wires, is formed on the lower surface of the resin layer 92. Via wires are also formed filling the through holes 96. Further, the wiring pattern 112, which is electrically connected to the wiring layer 84 by the via wires, is formed on the lower surface of the resin layer 92. Consequently, the wiring layer 110, which includes the wiring pattern 111 and the wiring pattern 112, is formed on the lower surface of the resin layer 92. The wiring layers 100 and 110 may be formed, for example, through any of various wiring formation processes such as a semi-additive process.

The semiconductor device 10C of the third embodiment is manufactured through the manufacturing steps described above. The semiconductor device 10C may be reversed upside-down for use or arranged at any angle.

The third embodiment has the same advantages as the first and second embodiments.

### Modified Examples

The above embodiments may be modified as described below. The above-described embodiments and the modified examples described below may be combined as long as there is no technical contradiction.

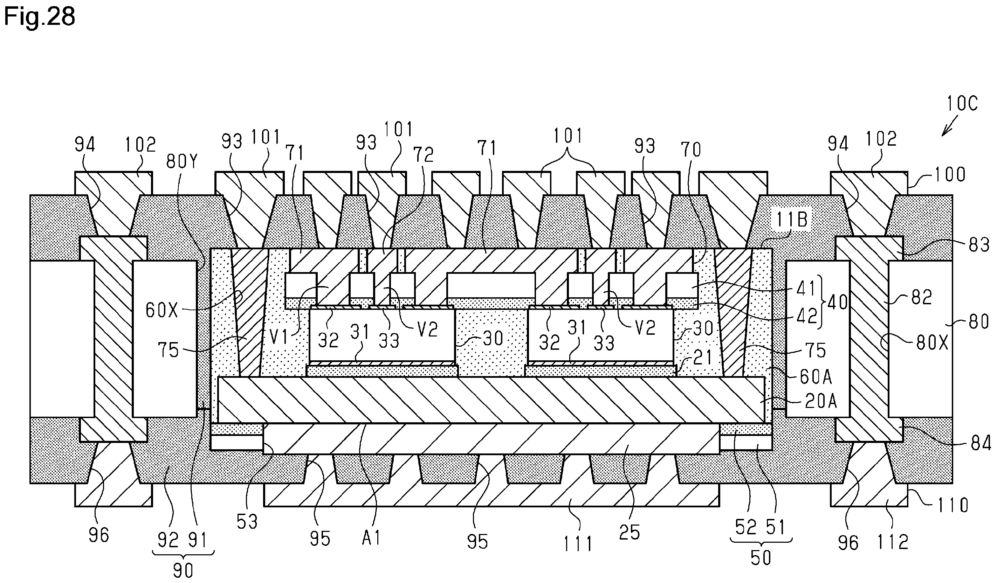

As illustrated in Fig. 28, a metal layer 25 may be formed on the lower surface of the metal plate 20A. The metal layer 25 is, for example, formed as a solid plane. The metal layer 25 entirely covers, for example, the lower surface of the metal plate 20A that is exposed from the open portion 53 of the second organic substrate 50. The metal layer 25 projects downward from, for example, the lower surface of the second organic substrate 50. In this case, the through holes 95, which extend through the resin layer 92 in the thickness direction, partially expose the lower surface of the metal layer 25. Further, the wiring pattern 111 is electrically connected to the metal layer 25 by via wires formed in the through holes 95.

The metal layer 25 may be formed, for example, through an electroless plating process, an electrolytic plating process, or a sputtering process. The material of the metal layer 25 may be copper or a copper alloy.

The metal plate 25 increases the heat capacity of the semiconductor device 10C. This limits increases in the temperature of the semiconductor device 10C when it is activated.

In the modified example illustrated in Fig. 28, the metal layer 25 may cover the lower surface of the second organic substrate 50. That is, the metal layer 25 may extend outward from the wall surfaces of the open portion 53. The metal layer 25 may extend outward, for example, until covering the lower surface of the substrate 80. In this case, the metal layer 25 extends around the second organic substrate 50. That is, the second organic substrate 50 is embedded in the metal layer 25.

In the third embodiment, the position where the structural body 11B is located in the resin layer 90 is not particularly limited. For example, the structural body 11B may be arranged in the resin layer 90 so that the lower surface of the second organic substrate 50 and the lower surface of the substrate 80 are located on the same plane.

In the above embodiments, the open portion 53 exposes the central part of the lower surface of each of the metal plates 20 and 20A. The open portion 53 may be structured differently as long as the lower surface of each of the metal plates 20 and 20A may be exposed.

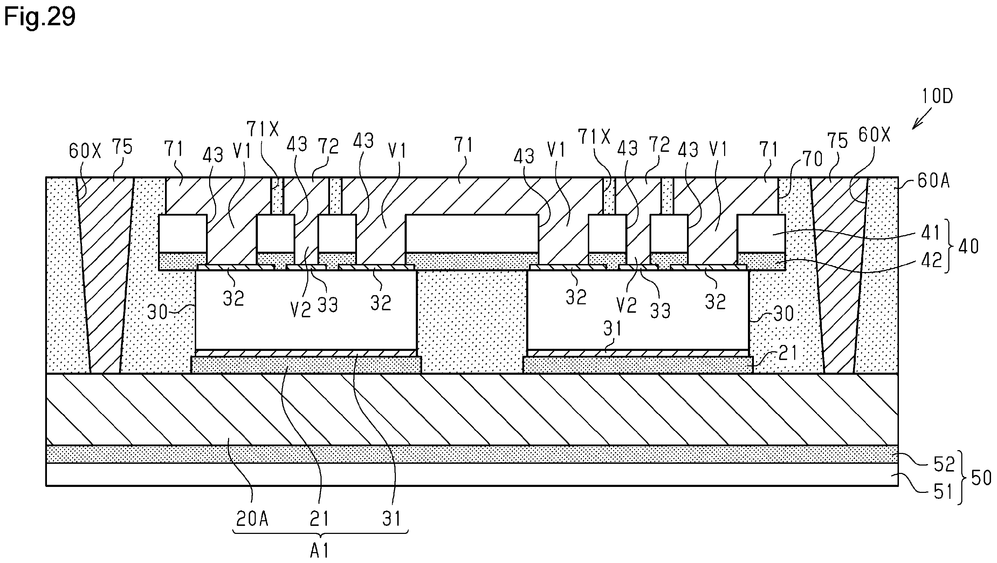

As illustrated in Fig. 29, the second organic substrate 50 may entirely cover the lower surface of the metal plate 20A. That is, the open portion 53 may be omitted from the second organic substrate 50.

In the above embodiments, the encapsulation resins 60 and 60A cover the outer side surfaces of the metal plates 20 and 20A. The encapsulation resins 60 and 60A may, however, be structured differently.

For example, Fig. 29 illustrates a semiconductor device 10D in which the outer side surfaces of the metal plate 20A are exposed from the encapsulation resin 60A. For example, the outer side surfaces of the metal plate 20A may be flush with the outer side surfaces of the encapsulation resin 60A. For example, the outer side surfaces of the metal plate 20A may be flush with the outer side surfaces of the second organic substrate 50.

In the above embodiments, the semiconductor elements 30 are joined with the same metal plate 20 or 20A. In particular, in the examples of the above embodiments, the four electrode pads 31 of the four semiconductor elements 30 are connected to the same metal plate 20 or 20A. This structure may be changed.

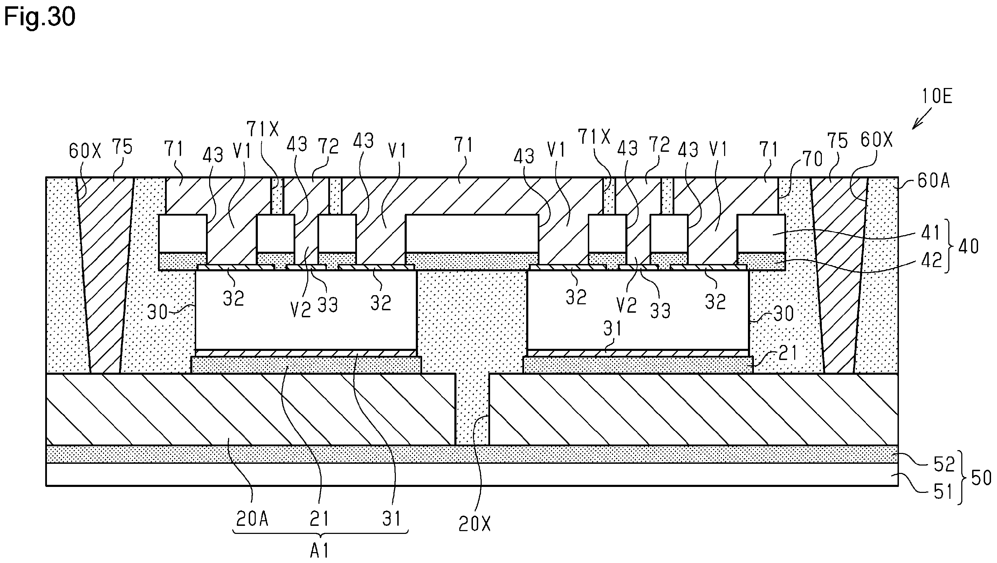

For example, Fig. 30 illustrates a semiconductor device 10E in which the metal plate 20A includes a through hole 20X. In other words, the metal plate 20A may be divided into several parts (e.g., four parts). In this case, the four semiconductor elements 30 are respectively joined with the divided four parts of the metal plate 20A. The encapsulation resin 60A, for example, fills the through hole 20X.

In the above embodiments, the second organic substrate 50 is bonded by the second adhesive layer 52 to the lower surface of the metal plate 20 or 20A. This structure may be changed. For example, the metal plates 20 and 20A may be replaced by a metal layer that is formed on the upper surface of the second substrate body 51. In this case, the metal layer is, for example, formed as a solid plane on the upper surface of the second substrate body 51. Further, the bonding portion 21 is formed on the upper surface of the metal layer, and the semiconductor elements 30 are bonded to the upper surface of the metal layer by the bonding portion 21. In this modified example, the second adhesive layer 52 is omitted from the second organic substrate 50.

In the above embodiments, the metal plate 20 or 20A is bonded by the bonding portion 21 to the lower surfaces of the electrode pads 31 of the semiconductor elements 30. This structure may be changed.

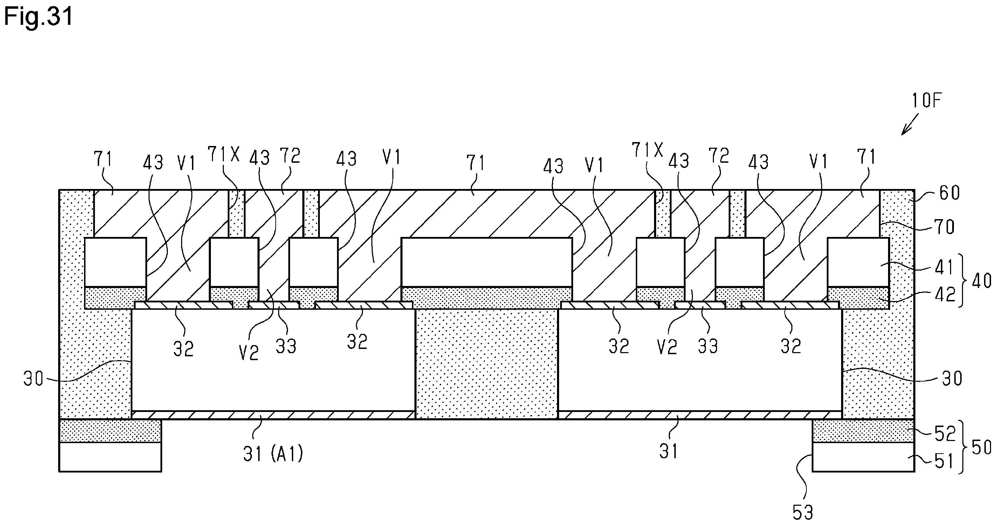

For example, Fig. 31 illustrates a semiconductor device 10F in which the metal plate 20 and the bonding portion 21 are omitted. In this case, the conductive layer A1 includes only the electrode pads 31. The second organic substrate 50 of this modified example is arranged on the lower surfaces of the electrode pads 31, which form the conductive layer A1. The second organic substrate 50 of this modified example covers at least the outer edges of the lower surface of the conductive layer A1. The second organic substrate 50 of this modified example is adhered to the lower surfaces of the electrode pads 31 by the second adhesive layer 52. The open portion 53 of this modified example exposes the lower surfaces of the electrode pads 31 and partially exposes the lower surface of the encapsulation resin 60.

Since the metal plate 20 and the bonding portion 21 are omitted in this structure, the semiconductor device 10F may be reduced in thickness. In the second embodiment, the metal plate 20A and the bonding portion 21 may be omitted from the semiconductor device 10B in the same manner.

In the third embodiment, the structure of the structural body 11B embedded in the resin layer 90 may be changed. For example, a structural body having the same structure as the semiconductor device 10A of the first embodiment may be embedded in the resin layer 90. For example, a structural body having the same structure as any one of the semiconductor devices 10D, 10E, and 10F in the modified examples may be embedded in the resin layer 90.

In the above embodiments, the planar shape of the wiring layer 70 may be changed.

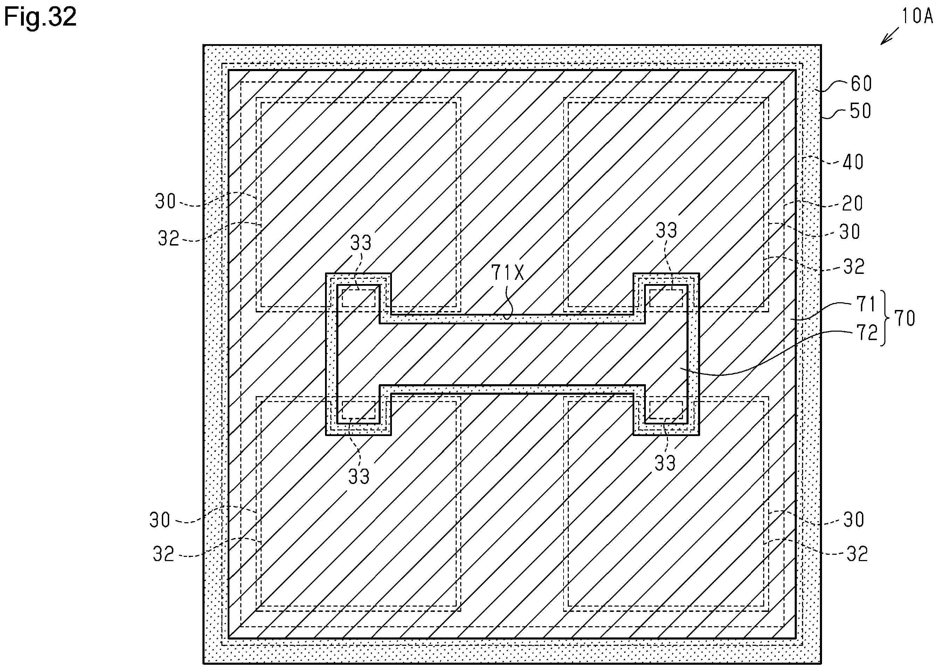

For example, as illustrated in Fig. 32, the planar shape of the wiring pattern 71 may be changed so that the open portion 71Y is not included. In this case, the wiring pattern 71 entirely surrounds the wiring pattern 72.

In the third embodiment, the layout and quantity of the wiring layers and insulation layers in the wiring structure formed on the upper surface of the substrate 80 may be changed.

In the third embodiment, the layout and quantity of the wiring layers and insulation layers in the wiring structure formed on the lower surface of the substrate 80 may be changed.

In the above embodiments, the upper surface of each of the encapsulation resins 60 and 60A is flush with the upper surface of the wiring layer 70. Instead, each of the encapsulation resins 60 and 60A may cover the upper surface of the wiring layer 70. Alternatively, a solder resist layer may be formed to cover the upper surface of the wiring layer 70. In this case, the encapsulation resins 60 and 60A and the solder resist layer may include openings that partially expose the upper surface of the wiring layer 70 as connection pads.

In the above embodiments, the upper surfaces of the encapsulation resins 60 and 60A may be located at a lower position than the upper surface of the wiring layer 70. In this case, the encapsulation resins 60 and 60A partially cover the side surfaces of the wiring layer 70 in the stacking direction. That is, the encapsulation resins 60 and 60A expose the upper part of the side surfaces of the wiring layer 70 in the stacking direction.

In the above embodiments, the encapsulation resins 60 and 60A expose the outer side surfaces of the second organic substrate 50 but may instead cover the outer side surfaces of the second organic substrate 50.

In the above embodiments, the encapsulation resin 60 and 60A cover the outer side surfaces of the first organic substrate 40 but may instead expose the outer side surfaces of the first organic substrate 40. In this case, the outer side surfaces of the encapsulation resins 60 and 60A may be, for example, flush with the outer side surfaces of the first organic substrate 40.

In the above embodiments, the structure of the through holes 43 is not particularly limited. For example, the through holes 43 may each be tapered so that is opening width (opening diameter) decreases from the upper surface of the first organic substrate 40 toward the electrode pads 32 and 33.

In the second embodiment, the structure of the through holes 60X is not particularly limited. For example, the wall surface of each through hole 60X may extend orthogonally to the upper surface of the first organic substrate 40.

In the third embodiment, the structure of the through holes 93 and 94 is not particularly limited. For example, the wall surface of each of the through holes 93 and 94 may extend orthogonally to the upper surface of the resin layer 91.

In the third embodiment, the structure of the through holes 95 and 96 is not particularly limited. For example, the wall surface of each of the through holes 95 and 96 may extend orthogonally to the lower surface of the resin layer 92.

In the above embodiments, the quantity of the semiconductor elements 30 is not particularly limited. For example, one, two, three, five, or more semiconductor elements 30 may be incorporated in the encapsulation resins 60 and 60A.

In the above embodiments, the first substrate body 41 of the first organic substrate 40 has a single-layer structure. This, however, is not a limitation. For example, the first substrate body 41 may be formed by stacking one or more wiring layers and one or more insulation layers.

In the above embodiments, the second substrate body 51 of the second organic substrate 50 has a single-layer structure. This, however, is not a limitation. For example, the second substrate body 51 may be formed by stacking one or more wiring layers and one or more insulation layers.

In the above embodiments and modified examples, the semiconductor devices 10A, 10B, 10C, 10D, 10E, and 10F are power semiconductor devices. This, however, is not a limitation. For example, the semiconductor devices 10A, 10B, 10C, 10D, 10E, and 10F may be any type of semiconductor device other than a power semiconductor device. For example, the structure and functionality of each of the semiconductor devices 10A, 10B, 10C, 10D, 10E, and 10F is not particularly limited as long as it includes the semiconductor elements 30, the first organic substrate 40, the conductive layer A1, the second organic substrate 50, the encapsulation resin 60, and the wiring layer 70.

In the above embodiments, the semiconductor elements 30 are power semiconductor elements. This, however, is not a limitation. For example, the semiconductor elements 30 may be any type of semiconductor element other than a power semiconductor element.

In the above embodiments, although the semiconductor elements 30 each include the three electrode pads 31, 32, and 33, there is no limit to the quantity of the electrode pads 31, 32, and 33. For example, the semiconductor elements 30 may each include two semiconductor elements.

## Claims

1. A semiconductor device (10A-10E), comprising:
at least one semiconductor element (30) including a first electrode pad (31) and a second electrode pad (32;33), the first electrode pad (31) formed on a lower surface of the semiconductor element (30) and the second electrode pad (32;33) formed on an upper surface of the semiconductor element (30);
a first organic substrate (40) arranged on the upper surface of the semiconductor element (30) to cover at least an outer edge of an upper surface of the second electrode pad (32;33);
a first wiring layer (70) arranged on an upper surface of the first organic substrate (40) and electrically connected to the second electrode pad (32;33);
a conductive layer (A1:20,21,31) formed on the lower surface of the semiconductor element (30);
a second organic substrate (50) arranged on a lower surface of the conductive layer (A1) to cover at least an outer edge of the lower surface of the conductive layer (Al); and
an encapsulation resin (60;60A) encapsulating the semiconductor element (30) between the first organic substrate (40) and the second organic substrate (50), wherein
the conductive layer (A1) includes:
the first electrode pad (31);
a metal plate (20;20A) arranged below the semiconductor element (30); and
a bonding portion (21) electrically connecting the metal plate (20;20A) and the first electrode pad (31),
the first organic substrate (40) includes a first substrate body (41) and a first adhesive layer (42) formed on a lower surface of the first substrate body (41) and adhered to the upper surface of the semiconductor element (30),
the second organic substrate (50) includes a second substrate body (51) and a second adhesive layer (52) formed on an upper surface of the second substrate body (51) and adhered to a lower surface of the metal plate (20;20A), and
the metal plate (20;20A) is thicker than the first organic substrate (40) and thicker than the second organic substrate (50).

2. The semiconductor device (10A-10E) according to claim 1, wherein
the first organic substrate (40) is formed from a resin having a withstand voltage higher than that of the encapsulation resin (60;60A), and
the second organic substrate (50) is formed from a resin having a withstand voltage higher than that of the encapsulation resin (60;60A).

3. The semiconductor device (10A-10E) according to claim 1 or 2, wherein a difference in thermal expansion coefficient between the first organic substrate (40) and the second organic substrate (50) is less than a difference in thermal expansion coefficient between the second organic substrate (50) and the semiconductor element (30).

4. The semiconductor device (10A-10C) according to any one of claims 1 to 3, wherein
the second organic substrate (50) projects outward from an outer side surface of the conductive layer (A1) in plan view,
the encapsulation resin (60;60A) is arranged on an upper surface of the second organic substrate (50) that is exposed from the conductive layer (A1), and
the encapsulation resin (60;60A) covers the outer side surface of the conductive layer (A1).

5. The semiconductor device (10A-10E) according to claim 4, wherein
the second organic substrate (50) projects outward from an outer side surface of the first organic substrate (40) in plan view, and
the encapsulation resin (60;60A) covers the outer side surface of the first organic substrate (40).

6. The semiconductor device (10B-10E) according to claim 1, wherein
the metal plate (20;20A) projects outward from an outer side surface of the first organic substrate (40) in plan view; and
the semiconductor device (10B-10E) further comprises
a through hole (60X) extending through the encapsulation resin (60;60A) in a thickness direction and partially exposing an upper surface of the metal plate (20;20A), and
a through-electrode (75) that fills the through hole (60X) and is electrically connected to the metal plate (20;20A).

7. The semiconductor device (10A-10C) according to claim 1, wherein the second organic substrate (50) includes an opening (53) extending through the second organic substrate (50) in a thickness direction and partially exposing the lower surface of the metal plate (20;20A).

8. The semiconductor device (10C) according to any one of claims 1 to 7, further comprising:
a structural body (11B) including the first organic substrate (40), the semiconductor element (30), the first wiring layer (70), the conductive layer (A1), the second organic substrate (50), and the encapsulation resin (60;60A);
a substrate (80) including an accommodation hole (80Y) in which the structural body (11B) is arranged;
a resin layer (90:91,92) covering an upper surface and a lower surface of the substrate (80), the resin layer (90:91,92) incorporating the structural body (11B); and
a second wiring layer (100) formed on an upper surface of the resin layer (90:91,92) and electrically connected to the first wiring layer (70).

9. The semiconductor device (10A-10E) according to claim 1, wherein
the encapsulation resin (60,60A) exposes the lower surface of the metal plate (20;20A), and
the second adhesive layer (52) is adhered to the lower surface of the metal plate (20;20A) and a lower surface of the encapsulation resin (60, 60A).

## Patentansprüche

1. Halbleitervorrichtung (10A-10E), umfassend:
mindestens ein Halbleiterelement (30) einschließlich eines ersten Elektrodenpads (31) und eines zweiten Elektrodenpads (32; 33), wobei das erste Elektrodenpad (31) auf einer unteren Oberfläche des Halbleiterelements (30) ausgebildet ist und das zweite Elektrodenpad (32; 33) auf einer oberen Oberfläche des Halbleiterelements (30) ausgebildet ist;
ein erstes organisches Substrat (40), das auf der oberen Oberfläche des Halbleiterelements (30) angeordnet ist, um mindestens eine äußere Kante einer oberen Oberfläche des zweiten Elektrodenpads (32; 33) zu bedecken;
eine erste Verdrahtungsschicht (70), die auf einer oberen Oberfläche des ersten organischen Substrats (40) angeordnet und elektrisch mit dem zweiten Elektrodenpad (32; 33) verbunden ist; eine leitfähige Schicht (A1:20,21,31), die auf der unteren Oberfläche des Halbleiterelements (30) ausgebildet ist;
ein zweites organisches Substrat (50), das auf einer unteren Oberfläche der leitfähigen Schicht (A1) angeordnet ist, um mindestens eine äußere Kante der unteren Oberfläche der leitfähigen Schicht (A1) zu bedecken; und
ein Verkapselungsharz (60; 60A), das das Halbleiterelement (30) zwischen dem ersten organischen Substrat (40) und dem zweiten organischen Substrat (50) verkapselt, wobei
die leitfähige Schicht (A1) Folgendes einschließt:
das erste Elektrodenpad (31);
eine Metallplatte (20; 20A), die unterhalb des Halbleiterelements (30) angeordnet ist; und
einen Bindeabschnitt (21), der die Metallplatte (20; 20A) und das erste Elektrodenpad (31) elektrisch verbindet,
wobei das erste organische Substrat (40) einen ersten Substratkörper (41) und eine erste Klebeschicht (42) einschließt, die auf einer unteren Oberfläche des ersten Substratkörpers (41) ausgebildet und mit der oberen Oberfläche des Halbleiterelements (30) verklebt ist,
das zweite organische Substrat (50) einen zweiten Substratkörper (51) und eine zweite Klebeschicht (52), die auf einer oberen Oberfläche des zweiten Substratkörpers (51) ausgebildet und mit einer unteren Oberfläche der Metallplatte (20; 20A) verklebt ist, einschließt und
die Metallplatte (20; 20A) dicker als das erste organische Substrat (40) und dicker als das zweite organische Substrat (50) ist.

2. Halbleitervorrichtung (10A-10E) nach Anspruch 1, wobei
das erste organische Substrat (40) aus einem Harz, das eine höhere Stehspannung als das des Verkapselungsharzes (60; 60A) aufweist, ausgebildet ist und
das zweite organische Substrat (50) aus einem Harz, das eine höhere Stehspannung als das des Verkapselungsharzes (60; 60A) aufweist, ausgebildet ist.

3. Halbleitervorrichtung (10A-10E) nach Anspruch 1 oder 2, wobei ein Unterschied in einem Wärmeausdehnungskoeffizienten zwischen dem ersten organischen Substrat (40) und dem zweiten organischen Substrat (50) geringer als ein Unterschied in einem Wärmeausdehnungskoeffizienten zwischen dem zweiten organischen Substrat (50) und dem Halbleiterelement (30) ist.

4. Halbleitervorrichtung (10A-10C) nach einem der Ansprüche 1 bis 3, wobei
das zweite organische Substrat (50) in einer Draufsicht von einer äußeren Seitenoberfläche der leitfähigen Schicht (A1) nach außen vorsteht,
das Verkapselungsharz (60; 60A) auf einer oberen Oberfläche des zweiten organischen Substrats (50), die von der leitfähigen Schicht (A1) freigelegt ist, angeordnet ist und
das Verkapselungsharz (60; 60A) die äußere Seitenoberfläche der leitfähigen Schicht (A1) bedeckt.

5. Halbleitervorrichtung (10A-10E) nach Anspruch 4, wobei
das zweite organische Substrat (50) in einer Draufsicht von einer äußeren Seitenoberfläche des ersten organischen Substrats (40) nach außen vorsteht und
das Verkapselungsharz (60; 60A) die äußere Seitenoberfläche des ersten organischen Substrats (40) bedeckt.

6. Halbleitervorrichtung (10B-10E) nach Anspruch 1, wobei
die Metallplatte (20; 20A) in einer Draufsicht von einer äußeren Seitenoberfläche des ersten organischen Substrats (40) nach außen vorsteht; und
die Halbleitervorrichtung (10B-10E) ferner Folgendes umfasst:
ein Durchgangsloch (60X), das sich in einer Dickenrichtung durch das Verkapselungsharz (60; 60A) erstreckt und eine obere Oberfläche der Metallplatte (20; 20A) teilweise freilegt, und
eine Durchgangselektrode (75), die das Durchgangsloch (60X) ausfüllt und elektrisch mit der Metallplatte (20; 20A) verbunden ist.

7. Halbleitervorrichtung (10A-10C) nach Anspruch 1, wobei das zweite organische Substrat (50) eine Öffnung (53) einschließt, die sich in einer Dickenrichtung durch das zweite organische Substrat (50) erstreckt und die untere Oberfläche der Metallplatte (20; 20A) teilweise freilegt.

8. Halbleitervorrichtung (10C) nach einem der Ansprüche 1 bis 7, ferner umfassend:
einen Strukturkörper (11B) einschließlich des ersten organischen Substrats (40), des Halbleiterelements (30), der ersten Verdrahtungsschicht (70), der leitfähigen Schicht (A1), des zweiten organischen Substrats (50) und des Verkapselungsharzes (60; 60A);
ein Substrat (80) einschließlich eines Aufnahmelochs (80Y), in dem der Strukturkörper (11B) angeordnet ist;
eine Harzschicht (90:91,92), die eine obere Oberfläche und eine untere Oberfläche des Substrats (80) bedeckt, wobei die Harzschicht (90:91,92) den Strukturkörper (11B) enthält; und
eine zweite Verdrahtungsschicht (100), die auf einer oberen Oberfläche der Harzschicht (90:91,92) ausgebildet und elektrisch mit der ersten Verdrahtungsschicht (70) verbunden ist.

9. Halbleitervorrichtung (10A-10E) nach Anspruch 1, wobei
das Verkapselungsharz (60, 60A) die untere Oberfläche der Metallplatte (20; 20A) freilegt und
die zweite Klebeschicht (52) mit der unteren Oberfläche der Metallplatte (20; 20A) und einer unteren Oberfläche des Verkapselungsharzes (60, 60A) verklebt ist.

## Revendications

1. Dispositif semi-conducteur (10A à 10E), comprenant :
au moins un élément semi-conducteur (30) comportant une première pastille d'électrode (31) et une seconde pastille d'électrode (32 ; 33), la première pastille d'électrode (31) étant formée sur une surface inférieure de l'élément semi-conducteur (30) et la seconde pastille d'électrode (32 ; 33) étant formée sur une surface supérieure de l'élément semi-conducteur (30) ;
un premier substrat organique (40) agencé sur la surface supérieure de l'élément semi-conducteur (30) pour recouvrir au moins un bord externe d'une surface supérieure de la seconde pastille d'électrode (32 ; 33);
une première couche de câblage (70) agencée sur une surface supérieure du premier substrat organique (40) et connectée électriquement à la seconde pastille d'électrode (32 ; 33);
une couche conductrice (A1 : 20, 21, 31) formée sur la surface inférieure de l'élément semi-conducteur (30) ;
un second substrat organique (50) agencé sur une surface inférieure de la couche conductrice (A1) pour recouvrir au moins un bord externe de la surface inférieure de la couche conductrice (A1) ; et
une résine d'encapsulation (60 ; 60A) encapsulant l'élément semi-conducteur (30) entre le premier substrat organique (40) et le second substrat organique (50), dans lequel
la couche conductrice (A1) comporte :
la première pastille d'électrode (31) ;
une plaque métallique (20 ; 20A) agencée sous l'élément semi-conducteur (30) ; et
une partie de liaison (21) connectant électriquement la plaque métallique (20 ; 20A) et la première pastille d'électrode (31), le premier substrat organique (40) comporte un premier corps de substrat (41) et une première couche adhésive (42) formée sur une surface inférieure du premier corps de substrat (41) et collée à la surface supérieure de l'élément semi-conducteur (30),
le second substrat organique (50) comporte un second corps de substrat (51) et une seconde couche adhésive (52) formée sur une surface supérieure du second corps de substrat (51) et collée à une surface inférieure de la plaque métallique (20 ; 20A), et
la plaque métallique (20 ; 20A) est plus épaisse que le premier substrat organique (40) et plus épaisse que le second substrat organique (50).

2. Dispositif semi-conducteur (10A à 10E) selon la revendication 1, dans lequel
le premier substrat organique (40) est formé d'une résine ayant une tension de tenue supérieure à celle de la résine d'encapsulation (60 ; 60A), et
le second substrat organique (50) est formé d'une résine ayant une tension de tenue supérieure à celle de la résine d'encapsulation (60 ; 60A).

3. Dispositif semi-conducteur (10A à 10E) selon la revendication 1 ou 2, dans lequel une différence de coefficient de dilatation thermique entre le premier substrat organique (40) et le second substrat organique (50) est inférieure à une différence de coefficient de dilatation thermique entre le second substrat organique (50) et l'élément semi-conducteur (30).

4. Dispositif semi-conducteur (10A à 10C) selon l'une quelconque des revendications 1 à 3, dans lequel
le second substrat organique (50) fait saillie vers l'extérieur à partir d'une surface latérale externe de la couche conductrice (A1) en vue de dessus,
la résine d'encapsulation (60 ; 60A) est agencée sur une surface supérieure du second substrat organique (50) qui est exposée par rapport à la couche conductrice (A1), et
la résine d'encapsulation (60 ; 60A) recouvre la surface latérale externe de la couche conductrice (A1).

5. Dispositif semi-conducteur (10A à 10E) selon la revendication 4, dans lequel
le second substrat organique (50) fait saillie vers l'extérieur à partir d'une surface latérale externe du premier substrat organique (40) en vue de dessus, et
la résine d'encapsulation (60 ; 60A) recouvre la surface latérale externe du premier substrat organique (40).

6. Dispositif semi-conducteur (10B à 10E) selon la revendication 1, dans lequel
la plaque métallique (20 ; 20A) fait saillie vers l'extérieur à partir d'une surface latérale externe du premier substrat organique (40) en vue de dessus ; et
le dispositif semi-conducteur (10B à 10E) comprend en outre un trou traversant (60X) s'étendant à travers la résine d'encapsulation (60 ; 60A) dans une direction d'épaisseur et exposant partiellement une surface supérieure de la plaque métallique (20 ; 20A), et
une électrode traversante (75) qui remplit le trou traversant (60X) et est électriquement connectée à la plaque métallique (20 ; 20A).

7. Dispositif semi-conducteur (10A à 10C) selon la revendication 1, dans lequel le second substrat organique (50) comporte une ouverture (53) s'étendant à travers le second substrat organique (50) dans une direction d'épaisseur et exposant partiellement la surface inférieure de la plaque métallique (20 ; 20A).

8. Dispositif semi-conducteur (10C) selon l'une quelconque des revendications 1 à 7, comprenant en outre :
un corps structurel (11B) comportant le premier substrat organique (40), l'élément semi-conducteur (30), la première couche de câblage (70), la couche conductrice (A1), le second substrat organique (50) et la résine d'encapsulation (60 ; 60A) ;
un substrat (80) comportant un trou d'accommodation (80Y) dans lequel le corps structurel (11B) est agencé ;
une couche de résine (90 : 91, 92) recouvrant une surface supérieure et une surface inférieure du substrat (80), la couche de résine (90 : 91, 92) incorporant le corps structurel (11B) ; et
une seconde couche de câblage (100) formée sur une surface supérieure de la couche de résine (90 : 91, 92) et connectée électriquement à la première couche de câblage (70).

9. Dispositif semi-conducteur (10A à 10E) selon la revendication 1, dans lequel
la résine d'encapsulation (60, 60A) expose la surface inférieure de la plaque métallique (20 ; 20A), et
la seconde couche adhésive (52) est collée à la surface inférieure de la plaque métallique (20 ; 20A) et à une surface inférieure de la résine d'encapsulation (60, 60A).
